(19) Europäisches Patentamt
European Patent Office
Office européen des brevets

(11) EP 4 501 502 A1

(12) **EUROPEAN PATENT APPLICATION**
published in accordance with Art. 153(4) EPC

(43) Date of publication:
**05.02.2025 Bulletin 2025/06**

(21) Application number: **23780864.7**

(22) Date of filing: **30.03.2023**

(51) International Patent Classification (IPC):
***B23B 27/14*** *(2006.01)* ***B23C 5/16*** *(2006.01)*
***C23C 16/34*** *(2006.01)* ***C23C 16/36*** *(2006.01)*

(52) Cooperative Patent Classification (CPC):
**B23B 27/14; B23C 5/16; C23C 16/34; C23C 16/36**

(86) International application number:
**PCT/JP2023/013155**

(87) International publication number:
**WO 2023/190856 (05.10.2023 Gazette 2023/40)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **30.03.2022 JP 2022056507**

(71) Applicant: **Mitsubishi Materials Corporation**
**Tokyo 100-8117 (JP)**

(72) Inventors:
- **YANAGISAWA, Kosuke**
  **Tokyo 100-8117 (JP)**
- **HOMMA, Hisashi**
  **Tokyo 100-8117 (JP)**

(74) Representative: **Gille Hrabal Partnerschaftsgesellschaft mbB**
**Patentanwälte**
**Brucknerstraße 20**
**40593 Düsseldorf (DE)**

(54) **SURFACE-COATED CUTTING TOOL**

(57) The surface coated cutting tool has the same multiple cutting edges. The coating layer of the flank face has a composition represented by $(Al_xTi_{1-x})(C_yN_{1-y})$ (the average content $x_{avg}$ of x is 0.60 to 0.95 and the average content $y_{avg}$ of y's is 0.0000 to 0.0050) ; the crystal grains in each flank face have an average value I(200) of 200 diffraction intensities and a standard deviation $\sigma_{I(200)}$, where the $\sigma_{I(200)}$/I(200) is 0.00 to 0.20; the average value $L_{avg}$ and standard deviation $\sigma_L$ of the thicknesses Lm's of the coating layer on a line 100 μm away from the ridge of each cutting edge in the direction of the flank face is within a $\sigma_L/L_{avg}$ of 0.00 to 0.20; and the coating layer on each flank face has a region containing variable amounts of Al and Ti, and the difference between the maximum $x_{max}$ and the minimum $x_{min}$ is 0.02 to 0.40.

[Fig.4]

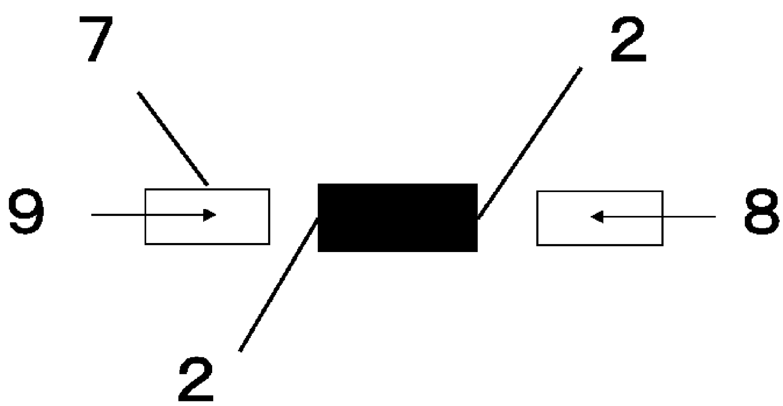

## Description

### Technical Field

The present invention relates to a surface coated cutting tool (hereinafter referred to as coated tool). This application claims priority based on Japanese Patent Application No. 2022-56507, filed on March 30, 2022. The entire description in the Japanese patent application is hereby incorporated by reference.

### Background Art

A coated cutting tool is known that has a coating layer formed on the surface of a substrate made of a tungsten carbide (WC) based cemented carbide. In order to ensure uniform cutting performance of multiple cutting edges of a coated tool, efforts have been made to make a coating layer with a homogeneous composition.

For example, PTL 1 describes a chemical vapor deposition system capable of forming a coating layer composed of a homogeneous composition on multiple substrates placed on a tray, and states that the coated tool produced in the system has a coating layer with a homogeneous composition, in detail, average contents of Al or Ti show small differences between the coating layers deposited on the substrates on the inner periphery and on the outer periphery of the tray.

### Citation List

### Patent Literature

PTL1: Japanese Patent Application Unexamined Publication No. 2017-20111

### Summary of Invention

### Technical Problem

Objects of the present invention, which was made in view of the aforementioned circumstances and proposals, are to define the degree of homogeneity of the coating layer and to provide a coated tool with a sufficient and uniform service life for all of multiple identical cutting edges, even in high-speed intermittent cutting operations.

### Solution to Problem

A surface coated cutting tool according to an embodiment of the present comprises:
a substrate and a coating layer disposed on the substrate, wherein

1.

(a) the coating layer comprises a complex nitride or carbonitride layer of Al and Ti including crystal grains with a face-centered cubic structure of a NaCl type,

(b) the tool includes a plurality of cutting edges having flank faces of the same shape, and the complex nitride or carbonitride layer of Al and Ti of all the flank faces has a composition represented by the formula $(Al_xTi_{1-x})(C_yN_{1-y})$ (where the average content $x_{avg}$ of x's is 0.60 or more and 0.95 or less, and the average content $y_{avg}$ of y's is 0.0000 or more and 0.0050 or less),

(c) 200 diffraction lines measured with an X-ray diffractometer at all the flank faces and assigned to the crystal grains with a face-centered cubic structure of a NaCl type in the coating layer have respective intensities, and the ratio $\sigma_{I(200)}/I_{avg}(200)$ is 0.00 or more and 0.20 or less where $I_{avg}(200)$ is the average intensity and $\sigma_{I(200)}$ is the standard deviation thereof,

(d) the coating layers of the cutting edges have respective intra-edge thicknesses Lm's on a line 100 $\mu$m away from the ridges of the cutting edges in the direction of the flank faces, and the ratio $\sigma_L/L_{avg}$ is 0.00 or more and 0.20 or less where $L_{avg}$ is the inter-edge average thickness of the intra-edge average thicknesses Lm's and $\sigma_L$ is the standard deviation thereof, and

(e) the complex nitride or carbonitride layer of Al and Ti of the flank faces of all the cutting edges contains columnar crystals having regions that satisfy the relation $0.02 \leq x_{max}-x_{min} \leq 0.40$, where $x_{max}$ is the average value of the maxima $x_{max}$* and $x_{min}$ is the average value of the minima $x_{min}$* of x's.

The surface coated cutting tool of the embodiment may further satisfy one or more of the following Items (1) to (5) .

(1) The average value $TC_{avg}(200)$ of the texture coefficient TC(200) of the crystal grains with the face-centered cubic structure of the NaCl type contained in the coating layer on the flank faces of all the cutting edges is 1.0 or more and 6.0 or less.

(2) On each of the flank faces of all the cutting edges, the average value $TC_{avg}(200)$ and the standard deviation $\sigma_{TC(200)}$of the texture coefficient TC(200) of the crystal grains with a face-centered cubic structure of a NaCl type contained in the coating layer satisfy a ratio $\sigma_{TC(200)}/TC_{avg}(200)$ of 0.00 or more and 0.10 or less.

(3) On each of the flank faces of all the cutting edges, a region containing variable amounts of Al and Ti in the coating layer occupies 70 area percent or more in a longitudinal section of the coating layer.

(4) On each of the flank faces of all the cutting edges, the columnar crystals of the complex nitride or carbonitride layer of Al and Ti have an average width W of 0.10 μm or more and 1.20 μm or less and an average aspect ratio A of 2.0 or more and 10.0 or less.

(5) The Al and Ti complex nitride layer or complex carbonitride layer contains chlorine in an amount of 0.005 atomic percent or more and 0.500 atomic percent or less.

## Advantageous Effects of Invention

The surface-coated cutting tools include a highly homogeneous coating layer and a plurality of cutting edges that all exhibit high thermal crack resistance and chipping resistance in high-speed intermittent cutting of alloy steel, carbon steel, and cast iron.

## Brief Description of Drawings

Fig. 1 is a cross-sectional view schematically illustrates an exemplary edge ridge at a cutting edge of an insert.

Fig. 2 is a schematic illustration of an exemplary edge corner at a cutting edge of an insert.

Fig. 3 is a schematic plan view of an exemplary arrangement of gas supply pipes in a chemical vapor deposition system for manufacturing surface-coated cutting tools.

Fig. 4 is a schematic side view of the device illustrated in Fig. 3.

Fig. 5 is a schematic view of a chemical vapor deposition system used in production of surface-coated cutting tools in Comparative Examples.

Fig. 6 is a schematic cross-section of a gas supply pipe in the system described in Figure 5.

## Description of Embodiments

In the case that a coated cutting tool is used in high-speed intermittent cutting, non-uniformity in thickness or inhomogeneity in composition of the coating layer causes the non-uniform or inhomogeneous portion to act as a starting point of fracture that induces thermal cracking and chipping. In the case of a single coated tool having multiple cutting edges, non-uniformity or inhomogeneity of the coating layer on each cutting edge causes variable cutting performance between the cutting edges, resulting in a difference in durability.

The inventors have examined variations in cutting performance and durability of each cutting edge. As a result, the inventors have found the following findings: In a coating layer composed of complex nitrides or carbonitride of Al and Ti (hereinafter, the complex nitride and carbonitride are collectively referred to as AlTiCN), if the coating layer contains both crystal grains oriented preferentially in the {111} plane and crystal grains oriented preferentially in the {100} plane or if crystal grains oriented preferentially in the {100} plane that can readily contain hexagonal crystal grains in grain boundaries, the growth rate of the crystal grains differs depending on differences in orientation and crystal system. Such a phenomenon leads to decreased uniformity or homogeneity in thickness, orientation, or composition of the coating layer between cutting edges of a single coated tool, resulting in variations in cutting performance and differences in durability.

Apart from this, the inventors have examined deposition of films with the deposition system described in PTL 1. As a result, the inventors concluded that the thickness and orientation of the coating layers and the homogeneity of crystallinity of the coating layers on the flank faces of the cutting edges of the cutting tool containing coating layers with different growth rates of crystal grains cannot be sufficiently equalized even in this deposition system. In other words, in the case that this coated tool is used for high-speed intermittent cutting of carbon steel, cast iron, and alloy steel, some cutting edges with shorter service life than that of other cutting edges are inevitably formed among the multiple cutting edges, failing to achieve uniform durability over the cutting edges.

Based on this recognition, the inventors have concluded that it is essential to specify, in particular, the allowable limits of uniformity or homogeneity in thickness, orientation, and crystallinity (extent of allowable non-uniformity or inhomogeneity) of the coating layer on the flank face in order for a coated tool having multiple cutting edges with coating layers containing crystal grains formed at different growth rate to achieve uniform thermal cracking resistance and chipping resistance in high-speed intermittent cutting of carbon steel, cast iron, and alloy steel. Thus, the inventors have made a diligent study on the allowable limits of uniformity or homogeneity in thickness and orientation of the coating layer on the flank faces of multiple cutting edges, and has obtained knowledge on these allowable limits. The inventors have also obtained knowledge of the physical properties required for the coating layer in the case that the coated tools having multiple cutting edges with coating layers containing crystal grains formed by different growth rates are used for high-speed intermittent cutting of carbon steel, cast iron, and alloy steel.

The embodiments of the invention will now be described in detail.

Throughout the specification and claims, the numerical range expressed as "L to M" (L and M are both numerical values) is synonymous with "L or more and M or less," and the range includes the lower limit (L) and the upper limit (M), and units listed only for the upper limit (M) apply to both the upper (M) and lower (L) limits.

The following are definitions on terms related to the coated tools according to the embodiments.

The term "high-speed intermittent cutting" as used herein refers to a cutting process that is performed at a higher cutting speed than that normally practiced by those skilled in the art in which the cutting edges of the cutting tool repeatedly cuts and idles.

Throughout the specification and claims, the term "longitudinal section" refers to a cross-section perpendicular to the surface of the substrate with proviso that the minute irregularities on the surface of the substrate and treats it as a flat surface are ignored in the insert. The substrate surface is defined as an average line (straight line) of the rough interface between the substrate and the coating layer in the observed image of the longitudinal section. The direction perpendicular to this average line shall be the direction perpendicular to the substrate (thickness direction of the coating layer).

Even if the substrate has a curved surface like a drill, the interface is substantially a flat plane between the coating layer and the substrate in the observing area in a tool having a diameter sufficiently large in relation to the thickness of the coating layer; hence, the surface of the substrate can be determined in the same manner.

Throughout the specification and claims, the cutting edge refers to a portion in contact with a work material during a cutting process.

1. Coating layer

The coating layer of this embodiment includes an AiTiCN layer. This layer will now be described in detail.

(1) Crystal grains with a face-centered cubic structure of NaCl type

In a single coated tool including multiple cutting edges of the same shape, the AlTiCN layer in the coating layer should contain crystal grains with a face-centered cubic structure of a NaCl type on the flank faces of all the cutting edges. For all the cutting edges, it is preferable that the area percent of crystal grains with a face-centered cubic structure of a NaCl type in the longitudinal section of the coating layer on the flank face is 50 area% or more, more preferably 70 area% or more, for the following reasons: An area percent of 50 area% or more can solve the aforementioned issue, whereas an area percent of less than 70 area% may cause the hardness to be low, resulting in insufficient wear resistance. The entire crystal grains may have a NaCl-type face-centered cubic structure (may be 100 area percent).

To confirm the presence of crystal grains with a face-centered cubic structure of a NaCl type constituting the AlTiCN layer, a sample is measured with, for example, a X-ray microdiffraction analyzer (example conditions: Cu-K$\alpha$ beam, output: 50 kV and 22 mA, step size: 0.02 mm, scan step time; 300 sec, detection distance: 150 mm, collimator diameter: 100 $\mu$m) to yield an X-ray diffraction pattern, and it is checked if X-ray diffraction peaks appear between the diffraction angles of the same crystal plane (e.g., 36.66 to 38.53°, 43.59 to 44.77°, 61.81 to 65.18°) in the X-ray diffraction patterns of JCPDS00-038-1420 cubic TiN and JCPDS00-046-1200 cubic AlN.

The presence of crystal grains with a face-centered cubic structure of a NaCl type constituting the AlTiCN layer may also be confirmed in combination with a method of determining the area percent of crystal grains with a face-centered cubic structure of a NaCl type constituting the AlTiCN layer, as described below. The measuring position should preferably be the observation field of view in the vicinity of the measuring position (within a radius of 50 $\mu$m from this measuring position) for determination of the intra-edge average thickness (Lm) of the AlTiCN layer on the flank face of each cutting edge, which will be described later.

The procedure for measuring the area percent of crystal grains with a face-centered cubic structure of NaCl type is as follows:

Grain boundaries are identified. The surface of the sample is polished to produce a surface polished longitudinal section. The electron beam is scanned at any beam diameter and interval to each measuring point while the surface is being precession-irradiated with electron beams inclined at an angle of 0.5 degrees to 1 degree relative to the normal direction of the polished surface using a crystal orientation analyzer attached to a transmission electron microscope (TEM) to continuously capture the electron diffraction pattern.

Individual measuring points are analyzed to determine the NaCl-type face-centered cubic structure and its crystal orientation. The grain boundary is then determined as described below in an observation field of view established such that, for example, the width is 2000 nm and the height includes the entire thickness of the coating layer.

The electron diffraction pattern used for the measurement is acquired under the conditions of, for example, an acceleration voltage of 200 kV, a camera length of 20 cm, a beam size of 2.4 nm, and a measurement step of 10.0 nm in the horizontal and vertical directions. The measured crystal orientation is discretely examined on the measuring plane, and the orientation distribution of the entire measuring plane is determined by representing the result of measurement on the area up to the middle between adjacent measuring points. For example, a square area (hereinafter referred to as "pixel") is representative of a measuring point.

If the angular difference in crystallographic orientation is 5 degrees or more between adjacent pixels, or if only one of the adjacent pixels shows a NaCl-type face-centered cubic structure, the edge of the region where these pixels are in contact with is defined as a grain boundary. The area enclosed by the periphery designated as a grain boundary is then defined as one crystal grain.

Pixels that exist alone, such as those that have an orientation difference of 5 degrees or more from all adjacent pixels or that have no measuring points with the adjacent NaCl-type face-centered cubic structure are not considered to be crystal grains, but those that have two or more pixels connected to each other are treated as crystal grains. In this way, grain boundaries are determined to identify crystal grains.

The area percent of the crystal grains with a face-centered cubic structure of a NaCl type corresponds to percentage of the total area of the crystal grains with the identified face-centered cubic structure of a NaCl type to the total area of the observation field of view. The same measurement is performed for each cutting edge in five or more observation fields, and the average value of the results observed for all cutting edges is defined as an area percentage of crystal grains with a face-centered cubic structure of a NaCl type constituting the AlTiCN layer.

(2) Composition of AlTiCN layer

The AlTiCN layer of each flank face of the cutting edges is preferably composed of $(Al_xTi_{1-x})(C_yN_{1-y})$ where the average content $x_{avg}$ of x's is 0.60 or more and 0.95 or less and the average content $y_{avg}$ of y's is 0.000 or more and 0.0050 or less.

An average content $x_{avg}$ of less than 0.60 is undesirable because of a decrease in thermal crack resistance, while an average content $x_{avg}$ of more than 0.95 is undesirable because of a decrease in wear resistance. An average content $y_{avg}$ within this range leads to an improvement in lubricity, and thus the mitigation of impact and an improvement in chipping resistance during cutting. An average content $x_{avg}$ between 0.75 and 0.95 contributes to a further advantageous enhancement in the aforementioned characteristics.

The average contents $x_{avg}$ and $y_{avg}$ in the AlTiCN layer can be determined as follows. The measuring position should preferably be the observation field of view near the measuring position (within a radius of 50 μm from this measuring position) where the intra-edge average thickness (Lm) of the AlTiCN layer on the flank face, which is described later for each cutting edge, is determined.

The content (x) of Al in the total amount of Al and Ti is determined as follows: For example, the surface of the longitudinal polished section of the coating layer near the measuring position is irradiated with electron beams using an electron probe microanalyzer (EPMA: electron probe microanalyzer); and the results of the characteristic X-ray analysis are averaged over 10 points. Alternatively, the content can be determined as follows: The surface of the longitudinal section is irradiated with electron beams in the thickness direction of the coating layer using energy dispersive X-ray spectroscopy (EDS); and the content is determined by analysis of compositions of Al and Ti.

The C content (y) is determined as follows: For example, the depth profile on the concentration of C is measured by secondary ion mass spectroscopy (SIMS) for a 70 μm by 70 μm area of the polished surface of the coating layer parallel to the substrate surface near the measuring position described above, and the average value is determined from the depth profile. Average values are then measured at different sites (e.g., three sites) in the coating layer on all cutting edges of the same shape in a single coated tool, and average $y_{avg}$ is determined by averaging the results of all the measurements.

The ratio $(Al_xTi_{1-x})/(C_yN_{1-y})$ may have any value. In a preferred embodiment, the ratio $(C_yN_{1-y})/(Al_xTi_{1-x})$ is 0.8 or more and 1.2 or less. A ratio $(C_yN_{1-y})/(Al_xTi_{1-x})$ within the range more reliably ensures the aforementioned object.

Even if the AlTiCN layer contains trace amounts of oxygen and other incidental impurities (impurities that are unintentionally included), it does not hinder the achievement of the aforementioned object.

(3) Average value and standard deviation of (200) diffraction intensities of crystal grains with a face-centered cubic structure of a NaCl type in AlTiCN layer

The crystal grains having a face-centered cubic structure of the NaCl type contained in the coating layer have 200 diffraction lines. The ratio $\sigma_{2(200)}/I_{avg}(200)$ measured using an X-ray diffraction device on the flank faces of all cutting edges should be more than 0.00 and less than 0.20, where $I_{avg}(200)$ is the average value of the (200) diffraction intensities and $\sigma_{I(200)}$ is the standard deviation thereof, for the following reasons.

The lower limit of the ratio $\sigma_{I(200)}/I(200)$ is 0.00 because it is desirable that standard variation is 0 (zero) in the (200) diffraction intensities due to a uniform average. A ratio $\sigma_{I(200)}/I_{avg}(200)$ exceeding 0.20 leads to decreases in crystallinity and uniformity of orientation of each cutting edge and thus decreases in the uniformity of thermal crack resistance and chipping resistance during high-speed intermittent cutting decreases. The term 200 diffraction line refers to the reflection indexed as (200) plane in XRD analysis.

The average value $I_{avg(200)}$ of (200) diffraction intensities and the standard deviation $\sigma_{I(200)}$ of crystal grains with a face-centered cubic structure of a NaCl type can be determined, for example, for each cutting edge as follows: A X-ray diffraction pattern is measured by X-ray micro-diffractometry (example measuring conditions: Cu-K$\alpha$ ray, output 50 kV, 22 mA, step size 0.02 mm, scan step time 300 sec, detection distance 150 mm, collimator diameter 100 $\mu$m) to determine (200) diffraction intensity. In this way, I(200) is measured for each cutting edge and averaged to determine $I_{avg}(200)$.

The measuring position is near the center of a line segment selected 500 $\mu$m from the cutting edge ridge and moved 100 $\mu$m parallel to the line segment in the direction of the flank face.

The standard deviation $\sigma_{I(200)}$ can be calculated by the following Expression 1:

$$\sigma_{I(200)} = \sqrt{\frac{\sum_{m=1}^{n}\left(I(200) - I_{avg}(200)\right)^2}{n}} \quad (1)$$

where n is the number of cutting edges having the same shape.

(4) Average value and standard deviation of thickness of AlTiCN layer at flank face

The cutting edges are each subjected to determination of the thicknesses of the AlTiCN layer at different points on a line 100 $\mu$m away from the ridge of the cutting edge in the direction of the flank face, and the thicknesses are averaged to determine the intra-edge average thickness Lm. The inter-edge average thickness $L_{avg}$ and standard deviation $\sigma_L$ of the intra-edge average thicknesses Lm's of all the cutting edges are then calculate. The ratio $\sigma_L/L_{avg}$ should preferably be 0.00 or more and 0.20 or less.

The inter-edge average thickness $L_{avg}$ should be 1.0 $\mu$m or more and 20.0 $\mu$m or less, for the following reasons: This range ensures sufficiently high abrasion resistance and superior chipping resistance. An inter-edge average thickness $L_{avg}$ of 3.0 $\mu$m or more and 15.0 $\mu$m or less further enhances such superior characteristics.

The reason for this is that the inter-edge average thickness $L_{avg}$ should be free from variation, i.e., the standard deviation $\sigma_L$ should be 0 (zero), so the lower limit of $\sigma_L/L_{avg}$ is 0.00. In contrast, a ratio $\sigma_L/L_{avg}$ of larger than 0.20 causes the coating layers to have uneven thicknesses every cutting edge due to a difference in deposition rate, resulting in decreases in uniformity of thermal crack resistance and chipping resistance under high-speed intermittent cutting.

With reference to Fig. 1, the rake face (1) and the flank face (2) of a cutting edge are approximated by straight lines (hereinafter referred to as approximate straight lines); an area between a first point where the straight line is separated from the rake face and a second point where the straight line is separated from the flank face (an area from a first point starting bending of the rake face to a second point starting bending of the flank face) is defined; and the ridge of the cutting edge is defined by a third point on the face of the coating layer closest to the intersection of the approximate straight lines (a third point indicated by the dotted arrow) between the first and second points.

In this embodiment, a coated tool having multiple cutting edges of the same shape is used to determine the intra-edge average thicknesses Lm's of the coating layer at different points on a line 100 $\mu$m away from the ridges of all the cutting edges in the direction of the flank face, and the inter-edge average thickness $L_{avg}$ and the standard deviation $\sigma_L$ of the intra-edge average thicknesses Lm's, as follows:

With reference to Fig. 2 that is a view from the rake face (1), the ridge of the cutting edge corresponds to the ridge (3) of the major cutting edge. The position on a line 100 $\mu$m away from the ridge of the cutting edge in the direction of the flank face is the position on a straight line parallel to the ridge (3) of the major cutting edge passing through a point 100 $\mu$m away in the direction of the flank surface starting from any point on the ridge (3) of the major cutting edge.

Specifically, in Figure 2, a first line segment 500 $\mu\mu$m from the ridge (3) of the cutting edge is selected, and the thicknesses of the coating layer are measured at multiple points separated by a predetermined distance from each other on a second line segment parallel to the first line segment by 100 $\mu$m in the direction of the flank face and are averaged to determine the intra-edge average thickness Lm's.

The multiple points on the second line segment that are separated from each other by a predetermined length can be, for example, four points spaced 30 $\mu$m apart. Instead, it is preferable to select more points. In this way, the intra-edge average thickness Lm is determined for each cutting edge and the average thicknesses of all the cutting edges are averaged into the inter-edge average thickness $L_{avg}$.

To measure the thickness, a sample of a longitudinal section of the coating layer is prepared with a cross-section polisher (CP) or similar device, and the cross-section is observed with a scanning electron microscope (SEM).

The standard deviation $\sigma_L$ is calculated by Expression 2:

$$\sigma_L = \sqrt{\frac{\sum_{m=1}^{n}(Lm - Lavg)^2}{n}} \quad (2)$$

where n is the number of cutting edges with the same shape.

In the case that the coated tool has two types of cutting edges with the same shape, one with sharp corners and the other with obtuse corners, the tool is treated as a surface coated cutting tool as long as either of them meets the requirements described in the specification and in the claims.

In the case of a circular insert with cutting edges present along the circumference of the circle, for example, two points may be selected, one at any point on the circumference and the other at a position 180 degrees rotated from the center of the circle with respect to that point, and each may be regarded as a cutting edge with the same shape as described above to determine the standard deviation.

(5) Area percent S of region of columnar crystals containing variable amounts of Al and Ti and maximum $x_{max}$ and minimum $x_{min}$ of x's

It is preferred that the AlTiCN layer on the flank face of each cutting edge contains columnar crystals and contains variable amounts of Al and Ti, and that the maximum $x_{max}$ and minimum $x_{min}$ of the content (percentage) (x) of Al in the total amount of Ti and Al within the variable amounts satisfy $0.02 \leq x_{max} - x_{min} \leq 0.40$. The columnar crystals refer to crystal grains with an aspect ratio A (definition will be described later) of 1.5 or more in the AlTiCN layer.

A value $x_{max} - x_{min}$ within this range leads to improved heat cracking resistance and chipping resistance of the coated tool. A value of less than 0.02 fails to satisfy such sufficient improvements. A value of greater than 0.40 leads to generation of large strain in the crystal grains constituting the AiTiCN layer, resulting in reductions in thermal cracking resistance and chipping resistance of the coated tool.

It is also preferred that the area percent containing variable amounts of Al and Ti (details will be described below) in the flank face of each cutting edge is 50 area percent or more, more preferably 70 area percent or more in the longitudinal section of the AlTiCN layer for the following reasons: Although the aforementioned issues can be solved at 50 area percent or more containing variable amounts of Al and Ti, the thermal crack resistance and chipping resistance of the coated tool under high-speed intermittent cutting may decrease at less than 70 area percent. The area containing variable amounts of Al and Ti may be 100 area percent in the longitudinal cross section of the coating layer.

In each cutting edge, the maximum $x_{max}$ and minimum $x_{min}$ of the content of Al in the total content of Ti and Al in variable amounts of Al and Ti, and the area percentage of the area containing variable amounts of Al and Ti in the coating layer can be determined, for example, as follows:

The longitudinal section of the coating layer is observed at appropriate magnifications ranging from 160,000x to 320,000x with an energy-dispersive X-ray spectrometer attached to a scanning transmission electron microscope (STEM).

The content (x) of Al in the total amount of Ti and Al in variable amounts of Al and Ti is determined over the entire rectangular observation field of view in the longitudinal section of the coating layer, which field is set such that the width in the direction parallel to the substrate surface is 2 $\mu$m or more and includes the entire thickness of the coating layer.

The observation field of view should preferably be in the vicinity of the measuring position (within a circle of 50 $\mu$m radius from this measuring position) for determining the intra-edge average thickness (Lm) of the AlTiCN layer on the flank face for each cutting edge as described above.

The distribution of the Al content (x) in the total amount of Ti and Al is determined for each crystal grain (columnar crystal) of NaCl-type face-centered cubic and hexagonal crystal structures included in the entire observation field of view. If both the maximum $x_{max}$* and minimum $x_{min}$* differ by $\pm$1% or more from their average value ($x_{avg}$*), the crystal grains are determined to contain variable amounts of Al and Ti.

In other words, the area containing variable amounts of Al and Ti refers to the area where the crystal grains determined to contain variable amounts of Al and Ti are grouped together (summed up). The average of the maximum value $x_{max}$* and minimum value $x_{min}$* measured in each crystal grain is the maximum value $x_{max}$ and minimum value $x_{min}$ at a certain cutting edge.

It is more preferred that the regions that differ by more than +1% (high Al-content regions) and those that differ by more than -1% (low Al-content regions) from the average value ($x_{avg}$*) in the regions containing variable amounts of Al and Ti are distributed in a network, layered or granular manner. It is further preferred that the minimum distance between the outer edges of the high Al-content regions separated by the low Al-content regions or between the outer edges of the low Al-content regions separated by the high Al-content regions is at least 1 nm and less 50 nm, for the following reasons.

A minimum value of the above distance with in above leads to improvements in heat cracking resistance and chipping resistance of the coated tool. The minimum value of less than 1 nm however leads to an insufficient improvement in heat cracking resistance, whereas the minimum value of 50 nm or more may lead to an insufficient improvement in chipping resistance.

The percentage of the total area of the crystal grains determined to contain variable amounts of Al and Ti in the observation field of view is defined as a percentage of the area containing variable amounts of Al and Ti occupying in the coating layer.

(6) Average value {$TC_{avg}(200)$} of texture coefficient TC(200)

The texture coefficient TC(200) of crystal grains with the face-centered cubic structure of the NaCl type on a line 100 μm away from the ridge in the direction of the flank face are determined for all the cutting edges. It is more preferred that the average value $TC_{avg}(200)$ be 1.0 or more and 6.0 or less, for the following reasons.

An average $TC_{avg}(200)$ of less than 1.0 may lead to a decrease in thermal cracking resistance at each cutting edge under high-speed intermittent cutting. The larger average $TC_{avg}(200)$ is, the better the thermal cracking resistance, and the maximum average $TC_{avg}(200)$ may be 6.0. An average $TC_{avg}(200)$ between 1.0 and 3.4 leads to excellent balance between thermal cracking resistance and wear resistance. An average $TC_{avg}(200)$ of 3.5 or more and 6.0 or less leads to excellent thermal crack resistance.

(7) Variation in texture coefficient TC (200)

It is more preferred that the ratio $\sigma_{TC(200)}/TC_{avg(200)}$ be 0.00 to less than 0.10 for the following reasons: A ratio $\sigma_{TC(200)}/TC_{avg}(200)$ of larger than 0.10 may lead to low uniformity of thermal crack resistance and chipping resistance at each cutting edge under high-speed intermittent cutting.

The texture coefficient TC (200) is determined as follows:

In the case that a single coated tool has multiple cutting edges, a 500 μm line segment is selected from the ridge at each cutting edge, and the measuring position is determined near the center of the line segment shifted 100 μm parallel to the direction of the flank face. At this measuring position, the X-ray diffraction pattern is acquired by micro X-ray diffractometry (example of measuring conditions: Cu-Kα beam, 50kV output, 22mA, detection distance 150mm, collimator diameter 100μmΦ).

In the case that 200 diffraction lines of crystal grains with a face-centered cubic structure of a NaCl type are observable, the texture coefficient TC(200) is calculated to determine the average value $TC_{avg}(200)$ and the corresponding standard deviation $\sigma_{TC(200)}$ at each cutting edge.

The texture coefficient TC (200) is defined as follows:

$$TC(200)=\{I(200)/I_0(200)\}\times[(1/6)\times\Sigma\{I(hkl)/I_0(hkl)\}]^{-1}.$$

The texture coefficient is measured for all the cutting edges and averaged into an average $TC_{avg}(200)$.

In the expression,

I(200): X-ray diffraction peak intensity observed at 200 diffraction line,

$I_0(200)$: Averaged standard X-ray diffraction peak intensity at 200 diffraction line of the crystal plane of AlN described in JCPDS card 00-046-1200,

Σ(I(hkl)/I0(hkl)): Sum of the values of ([observed X-ray diffraction peak intensities]/[averaged standard diffraction peak intensities of AlN listed in the ICDD card]) for 111, 200, 220, 311, 222 and 400 diffraction lines.

(8) Average width and average aspect ratio of columnar crystal grains

It is more preferred that the AlTiCN layer contain columnar crystal grains in the flank faces of all the cutting edges, that the average grain width W in the longitudinal section of the columnar crystals be between 0.1 μm and 2.0 μm, and that the average aspect ratio A be between 2.0 and 10.0, for the following reasons.

An average grain width W of smaller than 0.1 μm may lead to an increase in grain boundaries causing decreased plastic deformation resistance and decreased oxidation resistance, resulting in abnormal damage of the tool, while an average grain width W of larger than 2.0 μm may readily lead to a decrease in toughness due to the presence of coarsely grown grains.

Small crystal grains having an average aspect ratio A of smaller than 2.0 may cause the interface of the AlTiCN layer to act as the starting point for fracture against shear stress generated on the surface of the AlTiCN layer during cutting, resulting in chipping. An average aspect ratio A of greater than 10.0 may cause micro chipping to occur on the cutting edge during cutting and chipping occurring in the adjacent columnar crystal structure to decrease the drag force against the shear stress generated on the surface of the AlTiCN layer, resulting in sudden damage in the columnar crystal structure and thus large chipping.

Calculation of the average width W and average aspect ratio A of crystal grains with a face-centered cubic structure of a NaCl type for each cutting edge will now be described.

The longitudinal section of the AlTiCN layer is polished by the means described above.

The observation field of view should preferably be in the vicinity of the measuring position (within a circle of radius 50 μm from this measuring position) where the intra-edge average thickness (Lm) of the AlTiCN layer on the flank face is determined for each cutting edge as described above, and should preferably be a rectangle determined to include the entire thickness of the coating layer, with a size containing 20 or more crystal grains with a face-centered cubic structure of a NaCl type.

As mentioned above, the grain boundary is determined to identify the crystal grains. Image analysis is then performed to measure the maximum length $H_{ik}$ in the direction perpendicular to the surface of the substrate (the surface of the substrate is treated as a flat surface) at grain ik, the particle width $W_{ik}$, which is the maximum length parallel to the substrate at grain ik, and the area $S_{ik}$ of the grain ik, at a certain cutting edge k. The aspect ratio $A_{ik}$ of the grain ik is calculated by $A_{ik} = H_{ik}/W_{ik}$.

<Average width W of grains>

The widths ($W_1$ to $W_j$, $1 \leq i \leq jk$, where jk is the number of crystal grains per cutting edge, $jk \geq 20$) measured for 20 or more crystal grains in the observation field of view for each cutting edge k are area weighted averaged according to Expression 3 to determine the average width $W_k$ at a certain cutting edge k. Note that jk may be the same number for all cutting edges.

$$Wk = \frac{W_{1k}S_{1k} + W_{2k}S_{2k} + \cdot \cdot \cdot + W_{jk}S_{jk}}{S_{1k} + S_{2k} + \cdot \cdot \cdot + S_{jk}} \quad (3)$$

<Average aspect ratio>

For each cutting edge k, the aspect ratio $A_{jk}$ ($1 \leq i \leq jk$, $jk \geq 20$) is determined for 20 or more crystal grains in the observation field of view according to the definition, and the area weighted average is defined as an average aspect ratio Ak at a certain cutting edge k with Expression 4.

$$Ak = \frac{A_{1k}S_{1k} + A_{2k}S_{2k} + \cdot \cdot \cdot + A_{jk}S_{jk}}{S_{1k} + S_{2k} + \cdot \cdot \cdot + S_{jk}} \quad (4)$$

(9) Chlorine content

The AlTiCN layer may contain chlorine (Cl), and the average content of chlorine, if present, should preferably be 0.005 or more and 0.500 atomic percent or less. The average content in percentage of Cl is defined by {(number of Cl atoms)/(number of Cl atoms + number of Al atoms + number of Ti atoms + number of C atoms + number of N atoms)}×100.

The reason for determining the average percentage of chlorine content in the above range is that this range ensures an enhancement in the lubricity of the AlTiCN layer without a reduction in the toughness of the AlTiCN layer.

The average percentage of chlorine content in the AlTiCN layer is determined as follows. For example, a longitudinal polished section is irradiated with electron beams with an electron-probe-micro-analyzer (EPMA), and the resulting characteristic X-rays are analyzed to determine the percentage of chlorine content. The observation field of view should be in the vicinity of the measuring position (within a circle with a radius of 50 μm from the measuring point) where the intra-edge average thickness (Lm) of the AlTiCN layer on the flank face is determined for each cutting edge as described above, where several points (for example, 3 points) are observed for each coating layer on all cutting edges with the same shape in a single coated tool to determine the average chlorine content per cutting edge.

2. Other layers

2-1. Underlying layer

Although the AlTiCN layer alone has sufficient durability, an underlying layer including at least one sublayer composed of a Ti compound selected from the group consisting of titanium nitride, carbide, and carbonitride (the composition of the sublayer (s) may be non-stoichiometric. Any known composition may be used.) and having a total average thickness of 0.1 μm or more and 2.0 μm or less may be provided between the substrate and the AlTiCN layer. The underlying layer improves the adhesion between the AlTiCN layer and the substrate.

2-2. Overlying layer

An overlying layer may be provided on the AlTiCN layer. The overlying layer includes at least one sublayer composed of a Ti compound selected from the group consists of titanium nitride, carbide, carbonitride, and oxide, or composed of aluminum oxide (the composition of the sublayer(s) may be non-stoichiometric. Any known composition may be used.) and has a total average thickness of 0.1 μm or more and 4.0 μm or less. The overlying layer provides durability of the tool.

Both the underlying and overlying layers should preferably be deposited according to the method of producing the AlTiCN layer described below to eliminate a variation between cutting edges.

2-3. Unintended layers

An unintended layer other than the AlTiCN layer, underlying layer, and overlying layer may be deposited due to fluctuations in gas pressure and temperature in the deposition system during switching of deposition gases.

3. Substrate:

(1) Material

Any known material can be used for substrates suitable for achievement of the object of the invention. Examples include WC-based cemented carbides (WC containing Co and carbides of Ti, Ta, and Nb), Cermets (TiC, TiN, and TiCN), ceramics (titanium carbide, silicon carbide, silicon nitride, aluminum nitride, and aluminum oxide), and cBN sinters.

(2) Shape

The substrate may have any shape usable as a cutting tool. Examples of the shape include the shape of an insert and the shape of a drill.

4. Production

The AlTiCN layer according to the embodiment can be produced, for example, with the following deposition gases in a deposition system.

(1) Composition of deposition gas

The compositions of the reaction gases are exemplified as follows. The gas composition is the sum of the compositions of gas group A and gas group B as 100 % by volume, hereafter abbreviated as %.

Gas group A:
Composition: $TiCl_4$: 0.07 to 0.40%, $AlCl_3$: 0.20 to 1.29%, $N_2$: 0.0 to 10.0%, $C_2H_4$: 0.0 to 0.5%, $H_2$: balance.
Gas group B:

Composition $NH_3$: 1.00 to 4.40%, $H_2$: 25.0 to 35.0%.
Pressure of reaction atmosphere: 4.0 to 5.0 kPa
Temperature of reaction atmosphere: 700 to 850°C
Feed cycle: 1.00 to 5.00 seconds
Gas feed time per cycle: 0.15 to 0.25 seconds
Phase difference in gas feed between Gas group A and Gas group B: 0.10 to 0.20 seconds

The composition of deposition gas, pressure of the reaction atmosphere, temperature of the reaction atmosphere, feed cycle, gas feed time per cycle, and phase difference in gas feed between Gas group A and Gas group B indicate set values.

(2) Deposition system

Figs. 3 and 4 exemplify a deposition system provided with gas ejecting pipes (7). This deposition system is suited for a coated tool with four cutting edges where the deposition gas is ejected at the same timing toward the four flank faces of the tool such that the distance between any part of the cutting edge and the tip of the gas ejecting pipe (gas feeder) of the deposition system is the same.

The substrate (6) is placed on a flat-plate tray (not shown), and gas is injected into the space between the gas ejecting pipes from four directions. On deposition of the layer on the cutting edges on the bottom side of the substrate, for example, a spacer should be placed between the flat-plate tray and the substrate to create a gap, and then any part of the cutting edges should be placed at the same distance from the tip of the gas supply pipe of the deposition system.

The following description includes the following Appendices:

(Appendix 1) A surface coated cutting tool comprising a substrate and a coating layer disposed on the substrate, wherein,

(a) the coating layer comprises a complex nitride or carbonitride layer of Al and Ti including crystal grains with a face-centered cubic structure of a NaCl type,
(b) the tool includes a plurality of cutting edges having flank faces of the same shape, and the complex nitride or carbonitride layer of Al and Ti of all the flank faces has a composition represented by the formula $(Al_xTi_{1-x})(C_yN_{1-y})$ (where the average content $x_{avg}$ of x's is 0.60 or more and 0.95 or less, and the average content $y_{avg}$ of y's is 0.0000 or more and 0.0050 or less),
(c) 200 diffraction lines measured with an X-ray diffractometer at all the flank faces and assigned to the crystal grains with a face-centered cubic structure of a NaCl type in the coating layer have respective intensities, and the ratio $\sigma_{I(200)}/I(200)$ is 0.00 or more and 0.20 or less where I(200) is the average intensity and $\sigma_{I(200)}$ is the standard deviation thereof, (d) the coating layers of the cutting edges have respective intra-edge thicknesses Lm's on a line 100 $\mu$m away from the ridges of the cutting edges in the direction of the flank faces, and the ratio $\sigma_L/L_{avg}$ is 0.00 or more and 0.20 or less where $L_{avg}$ is the inter-edge average thickness of the intra-edge average thicknesses Lm's and $\sigma_L$ is the standard deviation thereof, and
(e) the comlex nitride or carbonitride layer of Al and Ti of the flank faces of all the cutting edges contains columnar crystals having regions that satisfy the relation $0.02 \leq x_{max}-x_{min} \leq 0$ 0.40, where $x_{max}$ is the average value of the maxima $x_{max}$* and $x_{min}$ is the average value of the minima $x_{min}$* of x's.

(Appendix 2) The surface coated cutting tool according to Appendix 1, wherein the average value $TC_{avg}(200)$ of the texture coefficient TC(200) of the crystal grains with the face-centered cubic structure of the NaCl type contained in the coating layer on the flank faces of all the cutting edges is 1.0 or more and 6.0 or less.

(Appendix 3) The surface coated cutting tool according to Appendix 1 or 2, wherein, on each of the flank faces of all the cutting edges, the average value $TC_{avg}(200)$ and the standard deviation $\sigma_{TC(200)}$of the texture coefficient TC(200) of the crystal grains with a face-centered cubic structure of a NaCl type contained in the coating layer satisfy a ratio $\sigma_{TC}$

(200)/$TC_{avg}$(200) of 0.00 or more and 0.10 or less.

(Appendix 4) The surface coated cutting tool according to any one of Appendices 1 to 3, wherein, on each of the flank faces of all the cutting edges, a region containing variable amounts of Al and Ti in the coating layer occupies 70 area percent or more in a longitudinal section of the coating layer.

(Appendix 5) The surface coated cutting tool according to any one of Appendices 1 to 4, wherein, on each of the flank faces of all the cutting edges, the columnar crystals of the complex nitride or carbonitride layer of Al and Ti has an average width W of 0.10 μm or more and 1.20 μm or less and an average aspect ratio A of 2.0 or more and 10.0 or less.

(Appendix 6) The surface coated cutting tool according to any one of Appendices 1 to 5, wherein the Al and Ti complex nitride layer or complex carbonitride layer contains chlorine in an amount of 0.005 atomic percent or more and 0.500 atomic percent or less.

(Appendix 7) The surface coated cutting tool according to any one of Appendices 1 to 6, wherein the region containing variable amounts of Al and Ti is distributed in a reticulate, layered or granular manner.

(Appendix 8) The surface coated cutting tool according to any one of Appendices 1 to 7, wherein an underlying layer is disposed between the substrate and the complex nitride or carbonitride layer of Al and Ti.

(Appendix 9) The surface coated cutting tool according to any one of Appendices 1 to 8, wherein an overlying layer is disposed on the complex nitride or carbonitride layer of Al and Ti.

Examples

Examples will now be described.

In Examples, the coated tool is applied to insert cutting tools including substrates composed of WC-based cemented carbide. The substrates may be composed of other materials mentioned above, and the shape of the substrate may be those of drills and end mills.

WC, TiC, ZrC, TaC, NbC, $Cr_3C_2$, TiN, and Co raw powders were prepared, and were blended into the compositions shown in Table 1.

Wax was added to each blend and the composition was mixed in acetone with a ball mill for 24 hours, was dried under reduced pressure, and was pressed into a green compact with a specified shape under a pressure of 98 MPa. The green compact was sintered under a vacuum at 5 Pa for 1 hour at 1420°C. WC-base cemented carbide substrates A to C with an insert geometry (four cutting edges) of SEMT13T3AGSN manufactured by Mitsubishi Materials Corporation and WC-base cemented carbide substrates D to F with an insert geometry (four cutting edges) of ISO standard CNMG120412 were thereby manufactured.

AlTiCN layers were formed on the surfaces of substrates A to F by CVD in a deposition system shown in Figs. 3 and 4 with the gas ejecting pipe arrangement to yield Examples 1 to 27 shown in Tables 7 and 8 under the deposition conditions shown in Table 2. The thickness of each coating layer was measured at four points separated by 30 μm on a line 100 μm away from the ridge of the cutting edge in the direction of the flank face and the results were averaged to determine the intra-edge average thickness Lm of the coating layer. The intra-edge average thicknesses Lm's were determined for all cutting edges and averaged into the inter-edge average thickness $L_{avg}$.

Some of Examples 1 to 27 each have an underlying layer or underlying and overlying layers as shown in Table 4. Those layers were deposited according to the deposition conditions shown in Table 3.

For comparison, AlTiCN layers were formed on the surfaces of Substrates A to F by CVD in a deposition system (Figs. 5 and 6) corresponding to the examples described in PTL 1, which was given as a prior art reference, with Symbols a to j indicating deposition conditions shown in Table 5 to yield comparative examples 1 to 15, shown in Tables 7 and 8.

Comparative examples 1 to 15 each have an underlying layer or underlying and overlying layers as shown in Table 6. These layers were deposited according to the deposition conditions shown in Table 3.

In the deposition system shown in Fig. 5, the bell-shaped reaction vessel (11) has a diameter of 250 mm and a height of 750 mm. An external heater (12) heated the inside of the reaction vessel (11) from 700°C to 1050°C. Disk shaped trays (13) with an outer diameter of 220 mm and a center hole of 65 mm in diameter were disposed in the vertical direction around the rotational shaft. Substrates A to F were placed on the trays (13) at intervals of 20 mm along the radial direction of the trays (13) and at approximately equal intervals along the circumferential direction of the trays (13).

The gas feeding pipe (14) was of the configuration shown in Fig. 6, and was spun around the rotation shaft (16) shown in Figs. 5 and 6 during deposition. The gas ejecting ports in the gas feeding pipe (14) are located next to each other in the circumferential direction, as shown in Fig. 6. One ejecting port (18) or two ejecting ports (19) and (20) were provided on both Gas groups A and B. In the case that two ejecting ports (19) and (20) are provided in the same gas group, their relative positions were defined by an angle $\alpha$ therebetween, as shown in Fig. 6. The number of ejecting ports for Gas groups A and Gas groups B is shown in Table 5.

A suit of ejecting port for gas group A and ejecting port for gas group B, which were positioned next to each other in the circumferential direction, were disposed in every space (15) between the trays supporting the substrate shown in Fig. 5. The gas flow rates of gas group A and gas group B ejected onto each tray are shown in Table 5.

In general, the chemical vapor deposition system used in production of surface-coated cutting tools includes a gas feed pipe installed in the center of a reaction vessel as shown in Figs. 5 and 6. In order to modify this system into the configuration shown in Figs. 3 and 4 as in the present embodiment, significant design changes are required with respect to the branching of the gas feed pipe and the trays for placing the substrate. Although Figs. 3 and 4 show examples of the deposition on a single substrate, multiple tools can be subjected to deposition of coating layers using such trays disposed in the vertical direction.

Tables 7, 8, 9, and 10 show the composition, area percentage of NaCl-type face-centered cubic structure, average thickness of the flank face, variations in Al and Ti contents, texture coefficient of the flank face, average crystal grain size, and aspect ratio for Examples 1 to 27 and Comparative Examples 1 to 15.

The observed value k for each cutting edge is distinguished by numbers 1 through 4.

[Table 1]

| Type | | Composition (mass%) | | | | | | | |
|---|---|---|---|---|---|---|---|---|---|
| | | Co | TiC | ZrC | TaC | NbC | $Cr_3C_2$ | TiN | WC |
| Substrate | A | 8.0 | 1.6 | 0.0 | 0.0 | 2.8 | 0.3 | 0.0 | Balance |
| | B | 8.0 | 0.0 | 0.0 | 1.6 | 0.5 | 0.0 | 0.0 | Balance |
| | C | 8.5 | 0.0 | 0.0 | 0.0 | 0.0 | 0.0 | 0.0 | Balance |
| | D | 7.0 | 0.0 | 1.2 | 0.0 | 2.9 | 0.5 | 1.0 | Balance |
| | E | 6.0 | 2.1 | 0.0 | 3.2 | 1.8 | 0.0 | 1.3 | Balance |
| | F | 8.0 | 0.0 | 0.0 | 0.0 | 0.0 | 0.2 | 0.0 | Balance |

[Table 2]

| Formation of AlTiCN layer | | | | | | | | | | | | | | | |
|---|---|---|---|---|---|---|---|---|---|---|---|---|---|---|---|
| Deposition process type | Symbol | Composition of Gas Group A (Volume%) | | | | | Composition of Gas Group B (Volume%) | | Gas Group A | | Gas Group B | | Defference in feed phase between Gas Groups A and B (sec.) | Reaction Atmosphere | |
| | | $TiCl_4$ | $AlCl_3$ | $N_2$ | $C_2H_4$ | $H_2$ | $NH_3$ | $H_2$ | Feed cycle (sec.) | Feed time per cycle (sec.) | Feed cycle (sec.) | Feed time per cycle (sec.) | | Pressure (kPa) | Temp. (°C) |
| Process of Examples | A | 0.13 | 0.20 | 0.0 | 0.0 | Balance | 1.00 | 25.0 | 2.00 | 0.16 | 2.00 | 0.16 | 0.10 | 5.0 | 850 |
| | B | 0.10 | 0.24 | 0.0 | 0.0 | Balance | 1.10 | 27.3 | 1.00 | 0.25 | 1.00 | 0.25 | 0.12 | 4.7 | 820 |
| | C | 0.33 | 1.05 | 10.0 | 0.5 | Balance | 3.50 | 35.0 | 5.00 | 0.15 | 5.00 | 0.15 | 0.14 | 4.0 | 700 |
| | D | 0.07 | 1.20 | 10.0 | 0.0 | Balance | 2.54 | 30.3 | 4.00 | 0.15 | 4.00 | 0.15 | 0.14 | 4.0 | 730 |
| | E | 0.09 | 0.90 | 5.0 | 0.0 | Balance | 2.40 | 26.4 | 3.00 | 0.17 | 3.00 | 0.17 | 0.15 | 4.5 | 760 |
| | F | 0.40 | 0.74 | 8.0 | 0.0 | Balance | 2.62 | 28.3 | 4.00 | 0.16 | 4.00 | 0.16 | 0.15 | 4.2 | 750 |
| | G | 0.20 | 0.80 | 6.0 | 0.2 | Balance | 2.40 | 34.4 | 3.00 | 0.20 | 3.00 | 0.20 | 0.18 | 4.5 | 800 |
| | H | 0.14 | 0.85 | 5.0 | 0.0 | Balance | 1.86 | 27.8 | 2.00 | 0.17 | 2.00 | 0.17 | 0.16 | 4.7 | 780 |
| | I | 0.19 | 0.93 | 6.0 | 0.0 | Balance | 3.40 | 31.3 | 3.00 | 0.22 | 3.00 | 0.22 | 0.20 | 4.0 | 800 |
| | J | 0.11 | 1.29 | 0.0 | 0.0 | Balance | 4.40 | 34.8 | 3.00 | 0.18 | 3.00 | 0.18 | 0.11 | 4.0 | 700 |
| | K | 0.14 | 0.52 | 0.0 | 0.0 | Balance | 2.62 | 32.4 | 2.00 | 0.21 | 2.00 | 0.21 | 0.18 | 4.2 | 760 |
| | L | 0.24 | 0.37 | 10.0 | 0.0 | Balance | 2.60 | 29.9 | 4.00 | 0.16 | 4.00 | 0.16 | 0.12 | 5.0 | 820 |
| | M | 0.39 | 0.70 | 5.0 | 0.5 | Balance | 3.75 | 26.7 | 3.00 | 0.22 | 3.00 | 0.22 | 0.16 | 4.0 | 850 |
| | N | 0.15 | 0.72 | 2.0 | 0.0 | Balance | 3.14 | 30.0 | 1.00 | 0.25 | 1.00 | 0.25 | 0.20 | 4.7 | 800 |
| | O | 0.22 | 0.49 | 6.0 | 0.2 | Balance | 3.21 | 34.3 | 2.00 | 0.19 | 2.00 | 0.19 | 0.13 | 5.0 | 800 |
| | P | 0.34 | 0.89 | 0.0 | 0.0 | Balance | 3.88 | 31.5 | 5.00 | 0.15 | 5.00 | 0.15 | 0.10 | 4.5 | 800 |
| | Q | 0.11 | 0.61 | 0.0 | 0.0 | Balance | 3.44 | 25.4 | 1.00 | 0.24 | 1.00 | 0.24 | 0.13 | 4.5 | 780 |
| | R | 0.07 | 0.22 | 2.0 | 0.0 | Balance | 1.06 | 28.6 | 4.00 | 0.18 | 4.00 | 0.18 | 0.17 | 4.2 | 780 |

[Table 3]

| Other layers | | Deposition Condition (Pressure of reaction atmosphere in kPa, and temperature in °C) | | |
|---|---|---|---|---|
| Type | | Composition of Reaction Gas (volume%) | Reaction atmosphere | |
| | | | Pressure | Temp. |
| Ti compound layer | TiN | $TiCl_4$: 4.2%, $N_2$: 30.0%, $H_2$: Balance | 30.0 | 850 |
| | TiCN | $TiCl_4$: 2.0%, $CH_3CN$: 1.0%, $N_2$: 15.0%, $H_2$: Balance | 7.0 | 900 |
| | TiCNO | $TiCl_4$: 2.0%, $CH_3CN$: 1.0%, CO: 1.0%, $N_2$: 5.0%, $H_2$: Balance | 13.0 | 900 |
| $Al_2O_3$ layer | $Al_2O_3$ | $AlCl_3$: 2.2%, $CO_2$: 5.5%, HCl: 2.2%, $H_2S$: 0.2%, $H_2$: Balance | 7.0 | 900 |

[Table 4]

| Type | | Substrate Symbol | Other layers (The lower number indicates the average thickness of the layer (μm)) | | | |
|---|---|---|---|---|---|---|
| | | | Underlying layer | | Overlying layer | |
| | | | 1st sublayer | 2nd sublayer | 1st sublayer | 2nd sublayer |
| Examples | 1 | A | - | - | - | - |
| | 2 | B | TiN (0.3) | TiCN (1.2) | - | - |
| | 3 | C | TiN (0.2) | - | - | - |
| | 4 | A | TiN (0.3) | - | TiCN (1.5) | - |
| | 5 | B | TiN (0.2) | - | - | - |
| | 6 | C | TiN (0.6) | TiCN (2.4) | $Al_2O_3$ (2.0) | - |
| | 7 | A | TiN (0.5) | TiCN (2.5) | TiCNO (0.3) | $Al_2O_3$ (1.7) |
| | 8 | B | TiN (0.6) | - | TiCNO (0.6) | $Al_2O_3$ (1.4) |
| | 9 | C | TiN (0.4) | - | - | - |
| | 10 | D | - | - | - | - |
| | 11 | E | TiN (0.5) | - | - | - |
| | 12 | F | TiN (0.5) | - | - | - |
| | 13 | D | TiN (0.5) | - | - | - |
| | 14 | E | TiN (1.0) | TiCN (1.5) | TiCNO (0.5) | $Al_2O_3$ (2.0) |
| | 15 | F | TiN (0.5) | - | - | - |
| | 16 | D | TiN (0.2) | - | TiCNO (0.7) | $Al_2O_3$ (2.6) |
| | 17 | E | TiN (0.4) | TiCN (2.0) | $Al_2O_3$ (1.3) | - |
| | 18 | F | TiN (0.7) | - | - | - |
| | 19 | B | TiN (0.3) | TiCN (1.1) | TiCNO (0.5) | $Al_2O_3$ (1.5) |
| | 20 | B | TiN (0.4) | - | - | - |
| | 21 | A | TiN (1.0) | - | - | - |
| | 22 | B | TiN (0.5) | - | - | - |
| | 23 | C | TiN (1.0) | TiCN (1.0) | - | - |
| | 24 | A | TiN (0.5) | - | $Al_2O_3$ (2.6) | - |
| | 25 | B | TiN (0.2) | - | - | - |
| | 26 | C | TiN (0.4) | TiCN (1.5) | - | - |
| | 27 | A | TiN (0.7) | - | - | - |

In Table 4, symbol "-" indicates no layer.

[Table 5]

| Deposition process type | Symbol | Formation of AlTiCN layer: Composition of Gas Group A (Volume%) | | | | | Composition of Gas Group B (Volume%) | | Gas group A | | | Gas group B | | | Rotation rate (rpm) | Reaction ambient | |
|---|---|---|---|---|---|---|---|---|---|---|---|---|---|---|---|---|---|
| | | $TiCl_4$ | $AlCl_3$ | $N_2$ | $C_2H_4$ | $H_2$ | $NH_3$ | $H_2$ | Gas flow rate per tray (SLM) | Number of ejecting ports | Angle between ejecting ports (degrees) | Gas flow rate per tray (SLM) | Number of ejecting ports | Angle between ejecting ports (degrees) | | Pressure (kPa) | Temp. (°C) |
| Process of Comparative Examples | a | 1.80 | 2.40 | 13.0 | 0.0 | Balance | 9.20 | 22.6 | 4.2 | 2 | 120 | 2.0 | 2 | 120 | 1 | 4.5 | 860 |
| | b | 0.10 | 3.00 | 0.0 | 0.0 | Balance | 3.60 | 40.0 | 2.6 | 1 | - | 2.0 | 2 | 155 | 5 | 4.0 | 800 |
| | c | 2.50 | 3.60 | 15.0 | 0.0 | Balance | 10.00 | 30.4 | 3.0 | 2 | 155 | 2.0 | 1 | - | 10 | 4.2 | 750 |
| | d | 1.10 | 4.50 | 0.0 | 0.8 | Balance | 6.00 | 30.6 | 3.2 | 2 | 50 | 1.8 | 2 | 50 | 2 | 5.5 | 690 |
| | e | 2.20 | 5.00 | 0.0 | 0.0 | Balance | 11.30 | 30.0 | 2.5 | 1 | - | 1.8 | 2 | 120 | 4 | 6.0 | 780 |
| | f | 2.10 | 2.41 | 10.9 | 0.0 | Balance | 8.27 | 24.3 | 2.8 | 1 | - | 1.4 | 1 | - | 2 | 6.0 | 800 |
| | g | 1.45 | 2.30 | 0.0 | 0.7 | Balance | 3.58 | 26.0 | 3.6 | 1 | - | 1.5 | 1 | - | 4 | 5.1 | 780 |
| | h | 0.80 | 3.64 | 0.0 | 0.9 | Balance | 9.59 | 33.5 | 4.0 | 2 | 150 | 3.0 | 2 | 150 | 8 | 4.3 | 720 |
| | i | 0.10 | 3.12 | 0.0 | 0.0 | Balance | 10.36 | 30.8 | 1.8 | 2 | 50 | 1.3 | 2 | 50 | 5 | 4.1 | 820 |
| | j | 0.92 | 4.10 | 7.0 | 0.0 | Balance | 6.40 | 22.1 | 2.4 | 1 | - | 1.0 | 1 | - | 1 | 5.6 | 690 |

In Table 5, "Angle between ejecting ports" refers to $\alpha$ in Fig. 6, and symbol "-" indicates no angle due to only one ejecting port.

[Table 6]

| Type | | Substrate Symbol | Other layers (The lower number indicates the average thickness of the layer (μm)) | | | |
|---|---|---|---|---|---|---|
| | | | Underlying layer | | Overlying layer | |
| | | | 1st sublayer | 2nd sublayer | 1st sublayer | 2nd sublayer |
| Comparative Examples | 1 | A | TiN (0.4) | - | - | - |
| | 2 | B | TiN (0.3) | - | - | - |
| | 3 | C | TiN (0.2) | TiCN (1.3) | - | - |
| | 4 | A | TiN (0.3) | - | $Al_2O_3$ (1.3) | - |
| | 5 | B | TiN (0.2) | - | - | - |
| | 6 | D | TiN (0.6) | TiCN (2.4) | - | - |
| | 7 | E | TiN (0.5) | TiCN (2.5) | TiCNO (0.5) | $Al_2O_3$ (1.5) |
| | 8 | F | TiN (0.4) | - | TiCNO (0.3) | $Al_2O_3$ (1.4) |
| | 9 | D | TiN (0.4) | TiCN (2.6) | - | - |
| | 10 | E | TiN (0.7) | - | $Al_2O_3$ (2.5) | - |
| | 11 | A | TiN (0.2) | - | - | - |
| | 12 | B | TiN (0.5) | - | TiCNO (0.5) | $Al_2O_3$ (1.0) |
| | 13 | C | TiN (0.4) | - | - | - |
| | 14 | A | TiN (0.4) | | - | - |
| | 15 | B | TiN (0.7) | - | - | - |

In Table 6, Symbol "-" indicates no layer.

[Table 7]

| Type | | Symbol for formation of TiAlCN | Are crystal grains with a face-centered cubic structure of a NaCl type present at least 70 area% at all cutting edges? | Average composition of TiAlCN layer (atomic fraction) | | | | | | | | | | | | | | |
|---|---|---|---|---|---|---|---|---|---|---|---|---|---|---|---|---|---|---|
| | | | | $x_{avg}1$ | $x_{avg}2$ | $x_{avg}3$ | $x_{avg}4$ | Is x between 0.60 and 0.95 for all cutting edges? | $y_{avg}1$ | $y_{avg}2$ | $y_{avg}3$ | $y_{avg}4$ | Is y between 0.0000 and 0.0050 for all cutting edges? | Cl content 1 (atomic%) | Cl content 2 (atomic%) | Cl content 3 (atomic%) | Cl content 4 (atomic%) | Do all cutting edges have a chlorine content of 0.005 to 0.500 atomic%? |
| Examples | 1 | A | Yes | 0.60 | 0.60 | 0.60 | 0.60 | Yes | 0.0001 > | 0.0001 > | 0.0001 > | 0.0001 > | Yes | 0.094 | 0.089 | 0.090 | 0.091 | Yes |
| | 2 | B | Yes | 0.71 | 0.71 | 0.71 | 0.71 | Yes | 0.0001 > | 0.0001 > | 0.0001 > | 0.0001 > | Yes | 0.102 | 0.105 | 0.101 | 0.102 | Yes |
| | 3 | C | Yes | 0.76 | 0.76 | 0.76 | 0.76 | Yes | 0.0049 | 0.0047 | 0.0048 | 0.0049 | Yes | 0.001 > | 0.001 > | 0.001 > | 0.001 > | No |
| | 4 | D | Yes | 0.94 | 0.95 | 0.94 | 0.94 | Yes | 0.0001 > | 0.0001 > | 0.0001 > | 0.0001 > | Yes | 0.574 | 0.588 | 0.577 | 0.584 | No |
| | 5 | E | Yes | 0.90 | 0.90 | 0.90 | 0.90 | Yes | 0.0001 > | 0.0001 > | 0.0001 > | 0.0001 > | Yes | 0.398 | 0.391 | 0.399 | 0.396 | Yes |
| | 6 | F | Yes | 0.65 | 0.65 | 0.64 | 0.65 | Yes | 0.0001 > | 0.0001 > | 0.0001 > | 0.0001 > | Yes | 0.002 | 0.002 | 0.003 | 0.004 | No |
| | 7 | G | Yes | 0.80 | 0.80 | 0.80 | 0.80 | Yes | 0.0020 | 0.0020 | 0.0019 | 0.0020 | Yes | 0.289 | 0.289 | 0.286 | 0.282 | Yes |
| | 8 | H | Yes | 0.86 | 0.85 | 0.85 | 0.85 | Yes | 0.0001 > | 0.0001 > | 0.0001 > | 0.0001 > | Yes | 0.196 | 0.190 | 0.195 | 0.191 | Yes |
| | 9 | I | Yes | 0.83 | 0.83 | 0.83 | 0.83 | Yes | 0.0001 > | 0.0001 > | 0.0001 > | 0.0001 > | Yes | 0.197 | 0.201 | 0.203 | 0.199 | Yes |
| | 10 | A | Yes | 0.61 | 0.61 | 0.61 | 0.61 | Yes | 0.0001 > | 0.0001 > | 0.0001 > | 0.0001 > | Yes | 0.097 | 0.096 | 0.097 | 0.096 | Yes |
| | 11 | B | Yes | 0.71 | 0.72 | 0.71 | 0.72 | Yes | 0.0001 > | 0.0001 > | 0.0001 > | 0.0001 > | Yes | 0.203 | 0.201 | 0.210 | 0.206 | Yes |
| | 12 | C | Yes | 0.76 | 0.76 | 0.76 | 0.76 | Yes | 0.0050 | 0.0049 | 0.0048 | 0.0048 | Yes | 0.005 | 0.005 | 0.005 | 0.005 | Yes |
| | 13 | D | Yes | 0.95 | 0.95 | 0.94 | 0.95 | Yes | 0.0001 > | 0.0001 > | 0.0001 > | 0.0001 > | Yes | 0.599 | 0.598 | 0.599 | 0.596 | No |
| | 14 | E | Yes | 0.91 | 0.91 | 0.90 | 0.91 | Yes | 0.0001 > | 0.0001 > | 0.0001 > | 0.0001 > | Yes | 0.392 | 0.396 | 0.386 | 0.391 | Yes |
| | 15 | F | Yes | 0.65 | 0.65 | 0.65 | 0.65 | Yes | 0.0001 > | 0.0001 > | 0.0001 > | 0.0001 > | Yes | 0.001 > | 0.001 > | 0.001 > | 0.001 > | No |
| | 16 | G | Yes | 0.80 | 0.80 | 0.80 | 0.80 | Yes | 0.0018 | 0.0022 | 0.0020 | 0.0019 | Yes | 0.201 | 0.199 | 0.201 | 0.202 | Yes |
| | 17 | H | Yes | 0.86 | 0.86 | 0.85 | 0.86 | Yes | 0.0001 > | 0.0001 > | 0.0001 > | 0.0001 > | Yes | 0.198 | 0.196 | 0.198 | 0.197 | Yes |
| | 18 | I | Yes | 0.82 | 0.84 | 0.83 | 0.84 | Yes | 0.0001 > | 0.0001 > | 0.0001 > | 0.0001 > | Yes | 0.204 | 0.206 | 0.201 | 0.206 | Yes |
| | 19 | J | No | 0.92 | 0.93 | 0.91 | 0.93 | Yes | 0.0001 > | 0.0001 > | 0.0001 > | 0.0001 > | Yes | 0.695 | 0.690 | 0.696 | 0.692 | No |
| | 20 | K | Yes | 0.79 | 0.79 | 0.79 | 0.79 | Yes | 0.0001 > | 0.0001 > | 0.0001 > | 0.0001 > | Yes | 0.206 | 0.204 | 0.206 | 0.205 | Yes |
| | 21 | L | Yes | 0.60 | 0.61 | 0.61 | 0.61 | Yes | 0.0001 > | 0.0001 > | 0.0001 > | 0.0001 > | Yes | 0.095 | 0.093 | 0.097 | 0.091 | Yes |
| | 22 | M | Yes | 0.64 | 0.64 | 0.65 | 0.64 | Yes | 0.0049 | 0.0049 | 0.0046 | 0.0047 | Yes | 0.101 | 0.100 | 0.105 | 0.101 | Yes |
| | 23 | N | Yes | 0.83 | 0.83 | 0.82 | 0.83 | Yes | 0.0001 > | 0.0001 > | 0.0001 > | 0.0001 > | Yes | 0.100 | 0.106 | 0.103 | 0.101 | Yes |
| | 24 | O | Yes | 0.69 | 0.69 | 0.69 | 0.69 | Yes | 0.0020 | 0.0019 | 0.0022 | 0.0024 | Yes | 0.299 | 0.298 | 0.299 | 0.294 | Yes |
| | 25 | P | Yes | 0.73 | 0.73 | 0.73 | 0.73 | Yes | 0.0001 > | 0.0001 > | 0.0001 > | 0.0001 > | Yes | 0.210 | 0.211 | 0.206 | 0.202 | Yes |
| | 26 | Q | Yes | 0.85 | 0.85 | 0.85 | 0.85 | Yes | 0.0001 > | 0.0001 > | 0.0001 > | 0.0001 > | Yes | 0.294 | 0.291 | 0.288 | 0.296 | Yes |
| | 27 | R | Yes | 0.76 | 0.76 | 0.75 | 0.76 | Yes | 0.0001 > | 0.0001 > | 0.0001 > | 0.0001 > | Yes | 0.193 | 0.191 | 0.201 | 0.194 | Yes |
| Comparative Examples | 1 | a | No | 0.58 | 0.61 | 0.64 | 0.59 | No | 0.0001 > | 0.0001 > | 0.0001 > | 0.0001 > | Yes | 0.888 | 0.869 | 0.882 | 0.880 | No |
| | 2 | b | - | 0.96 | 0.98 | 0.95 | 0.96 | No | 0.0001 > | 0.0001 > | 0.0001 > | 0.0001 > | Yes | 1.570 | 1.395 | 1.443 | 1.565 | No |
| | 3 | c | Yes | 0.59 | 0.62 | 0.58 | 0.63 | No | 0.0001 > | 0.0001 > | 0.0001 > | 0.0001 > | Yes | 0.203 | 0.206 | 0.211 | 0.209 | Yes |
| | 4 | d | Yes | 0.80 | 0.83 | 0.79 | 0.84 | Yes | 0.0074 | 0.0078 | 0.0061 | 0.0066 | No | 0.801 | 0.784 | 0.796 | 0.786 | No |
| | 5 | e | Yes | 0.69 | 0.73 | 0.69 | 0.74 | Yes | 0.0001 > | 0.0001 > | 0.0001 > | 0.0001 > | Yes | 0.406 | 0.408 | 0.402 | 0.405 | Yes |
| | 6 | a | Yes | 0.59 | 0.59 | 0.60 | 0.59 | No | 0.0001 > | 0.0001 > | 0.0001 > | 0.0001 > | Yes | 0.705 | 0.709 | 0.694 | 0.701 | No |
| | 7 | b | - | 0.97 | 0.96 | 0.98 | 0.96 | No | 0.0001 > | 0.0001 > | 0.0001 > | 0.0001 > | Yes | 1.104 | 1.068 | 1.058 | 1.100 | No |
| | 8 | c | Yes | 0.59 | 0.59 | 0.59 | 0.59 | No | 0.0001 > | 0.0001 > | 0.0001 > | 0.0001 > | Yes | 0.098 | 0.102 | 0.105 | 0.103 | Yes |
| | 9 | d | No | 0.81 | 0.80 | 0.81 | 0.80 | Yes | 0.0079 | 0.0074 | 0.0080 | 0.0081 | No | 0.703 | 0.692 | 0.701 | 0.700 | No |
| | 10 | e | Yes | 0.68 | 0.72 | 0.69 | 0.73 | Yes | 0.0001 > | 0.0001 > | 0.0001 > | 0.0001 > | Yes | 0.296 | 0.294 | 0.298 | 0.291 | Yes |
| | 11 | f | Yes | 0.54 | 0.56 | 0.55 | 0.57 | No | 0.0001 > | 0.0001 > | 0.0001 > | 0.0001 > | Yes | 0.103 | 0.099 | 0.104 | 0.101 | Yes |
| | 12 | g | Yes | 0.61 | 0.63 | 0.62 | 0.61 | Yes | 0.0065 | 0.0068 | 0.0061 | 0.0066 | No | 0.098 | 0.101 | 0.097 | 0.095 | Yes |
| | 13 | h | Yes | 0.82 | 0.87 | 0.83 | 0.88 | Yes | 0.0087 | 0.0081 | 0.0085 | 0.0086 | No | 0.296 | 0.307 | 0.292 | 0.303 | Yes |
| | 14 | i | No | 0.97 | 0.97 | 0.96 | 0.98 | No | 0.0001 > | 0.0001 > | 0.0001 > | 0.0001 > | Yes | 0.889 | 0.884 | 0.889 | 0.885 | No |
| | 15 | j | Yes | 0.82 | 0.82 | 0.82 | 0.82 | Yes | 0.0001 > | 0.0001 > | 0.0001 > | 0.0001 > | Yes | 0.105 | 0.101 | 0.112 | 0.108 | Yes |

In the column "Are crystal grains with a face-centered cubic structure of a NaCl type present at least 70 area% at all cutting edges?" in Table 7, "Yes" indicates affirmation, and "No" indicates that crystal grains with a face-centered cubic structure of a NaCl type are present in 50 area percent or more and less than 70 area percent in one or more cutting edges.

In the other columns, "Yes" indicates affirmation, and "No" indicates denial.

[Table 8]

| Type | | X-ray diffraction intensity I(200) of flank face | Average thickness of flank face | | | | | | Region with variable Al and Ti contents | | | | | |
|---|---|---|---|---|---|---|---|---|---|---|---|---|---|---|
| | | $\sigma_{I(200)}$/I(200) | Lm1 (μm) | Lm2 (μm) | Lm3 (μm) | Lm4 (μm) | Average thickness $L_{avg}$ (μm) | $\sigma/L_{avg}$ | Present on all cutting edges? | S1 (area%) | S2 (area%) | S3 (area%) | S4 (area%) | Are all cutting edges 70 area percent or more? |
| Examples | 1 | 0.18 | 5.2 | 5.0 | 5.0 | 4.9 | 5.0 | 0.02 | Yes | 57 | 59 | 63 | 59 | No |
| | 2 | 0.05 | 6.6 | 6.1 | 6.2 | 6.2 | 6.3 | 0.03 | Yes | 61 | 63 | 62 | 64 | No |
| | 3 | 0.19 | 7.6 | 7.1 | 9.9 | 7.0 | 7.9 | 0.15 | Yes | 99 | 94 | 95 | 98 | Yes |
| | 4 | 0.16 | 3.5 | 3.8 | 3.5 | 3.6 | 3.6 | 0.03 | Yes | 68 | 71 | 69 | 72 | No |
| | 5 | 0.02 | 3.3 | 2.5 | 2.9 | 2.7 | 2.9 | 0.10 | Yes | 76 | 77 | 80 | 79 | Yes |
| | 6 | 0.17 | 7.5 | 7.2 | 6.9 | 7.0 | 7.2 | 0.03 | Yes | 83 | 85 | 89 | 82 | Yes |
| | 7 | 0.19 | 3.3 | 3.5 | 3.0 | 2.9 | 3.2 | 0.08 | Yes | 83 | 86 | 81 | 84 | Yes |
| | 8 | 0.12 | 7.0 | 7.1 | 7.0 | 6.8 | 7.0 | 0.02 | Yes | 75 | 70 | 72 | 74 | Yes |
| | 9 | 0.04 | 2.8 | 1.9 | 1.9 | 2.0 | 2.2 | 0.18 | Yes | 80 | 85 | 80 | 78 | Yes |
| | 10 | 0.20 | 12.9 | 12.0 | 12.1 | 11.6 | 12.2 | 0.04 | Yes | 60 | 63 | 62 | 66 | No |
| | 11 | 0.11 | 15.4 | 15.5 | 14.2 | 14.3 | 14.9 | 0.04 | Yes | 67 | 68 | 63 | 63 | No |
| | 12 | 0.03 | 17.7 | 17.2 | 15.9 | 16.6 | 16.9 | 0.04 | Yes | 100 | 96 | 100 | 99 | Yes |
| | 13 | 0.18 | 11.1 | 11.6 | 12.0 | 12.4 | 11.8 | 0.04 | Yes | 77 | 75 | 81 | 75 | Yes |
| | 14 | 0.07 | 10.4 | 11.8 | 10.9 | 12.2 | 11.3 | 0.06 | Yes | 78 | 83 | 80 | 81 | Yes |
| | 15 | 0.15 | 18.9 | 18.6 | 15.8 | 17.2 | 17.6 | 0.07 | Yes | 78 | 74 | 81 | 80 | Yes |
| | 16 | 0.10 | 16.2 | 16.6 | 16.5 | 14.7 | 16.0 | 0.05 | Yes | 80 | 76 | 78 | 77 | Yes |
| | 17 | 0.19 | 11.6 | 11.8 | 13.3 | 12.0 | 12.2 | 0.05 | Yes | 71 | 72 | 73 | 74 | Yes |
| | 18 | 0.18 | 19.4 | 19.2 | 19.3 | 19.4 | 19.3 | 0.00 | Yes | 81 | 73 | 76 | 79 | Yes |
| | 19 | 0.04 | 3.8 | 3.6 | 3.5 | 4.0 | 3.7 | 0.05 | Yes | 54 | 52 | 58 | 56 | No |
| | 20 | 0.03 | 3.1 | 2.5 | 2.4 | 3.2 | 2.8 | 0.13 | Yes | 69 | 74 | 66 | 79 | No |
| | 21 | 0.02 | 5.1 | 5.5 | 4.9 | 4.7 | 5.1 | 0.06 | Yes | 77 | 68 | 72 | 63 | No |
| | 22 | 0.00 | 4.5 | 4.3 | 4.0 | 4.3 | 4.3 | 0.04 | Yes | 77 | 75 | 80 | 84 | Yes |
| | 23 | 0.06 | 1.4 | 1.0 | 1.2 | 1.0 | 1.2 | 0.14 | Yes | 70 | 73 | 62 | 74 | No |
| | 24 | 0.01 | 7.5 | 7.1 | 6.9 | 7.3 | 7.2 | 0.03 | Yes | 62 | 54 | 59 | 51 | No |
| | 25 | 0.03 | 6.1 | 6.3 | 5.9 | 6.5 | 6.2 | 0.04 | Yes | 81 | 85 | 79 | 82 | Yes |
| | 26 | 0.02 | 2.4 | 2.6 | 2.2 | 2.5 | 2.4 | 0.06 | Yes | 69 | 68 | 66 | 60 | No |
| | 27 | 0.06 | 4.0 | 3.8 | 3.6 | 3.9 | 3.8 | 0.04 | Yes | 73 | 74 | 79 | 71 | Yes |
| Comparative Examples | 1 | - | 1.5 | 0.8 | 1.1 | 0.6 | 1.0 | 0.34 | Yes | 56 | 47 | 62 | 51 | No |
| | 2 | 0.58 | 5.2 | 4.5 | 3.0 | 3.6 | 4.1 | 0.21 | No | - | - | - | - | - |
| | 3 | 0.25 | 8.1 | 4.1 | 7.2 | 5.4 | 6.2 | 0.25 | Yes | 81 | 70 | 78 | 71 | Yes |
| | 4 | - | 6.1 | 10.6 | 5.2 | 10.2 | 8.0 | 0.30 | Yes | 45 | 55 | 41 | 53 | No |
| | 5 | - | 8.5 | 7.4 | 9.1 | 4.6 | 7.4 | 0.23 | No | 64 | - | 69 | - | No |
| | 6 | 0.31 | 20.6 | 13.1 | 16.4 | 12.4 | 15.6 | 0.21 | Yes | 71 | 56 | 68 | 51 | No |
| | 7 | 0.41 | 12.5 | 7.9 | 12.4 | 7.7 | 10.1 | 0.23 | No | - | - | - | - | - |
| | 8 | 0.16 | 13.8 | 9.0 | 13.3 | 8.7 | 11.2 | 0.21 | Yes | 78 | 81 | 82 | 74 | Yes |
| | 9 | - | 17.5 | 11.5 | 14.9 | 10.4 | 13.6 | 0.21 | Yes | 56 | 51 | 48 | 59 | No |
| | 10 | - | 22.5 | 12.4 | 26.1 | 15.1 | 19.0 | 0.29 | No | 69 | - | 74 | - | No |
| | 11 | 0.39 | 2.1 | 1.0 | 2.4 | 1.5 | 1.8 | 0.31 | No | - | - | - | - | - |
| | 12 | - | 4.5 | 2.4 | 4.6 | 1.9 | 3.4 | 0.36 | No | - | - | - | - | - |
| | 13 | 0.55 | 3.5 | 2.8 | 2.4 | 4.3 | 3.3 | 0.22 | Yes | 55 | 36 | 46 | 50 | No |
| | 14 | 0.29 | 6.2 | 3.4 | 6.6 | 2.8 | 4.8 | 0.35 | No | - | - | - | - | Yes |
| | 15 | 0.32 | 7.4 | 2.9 | 5.7 | 2.4 | 4.6 | 0.45 | Yes | 72 | 62 | 68 | 59 | No |

On the column "Are all cutting edges are 70 area% or more?" in Table 8, "Yes" indicates affirmation, "No" indicates that one or more cutting edges are 50 area% or more and less than 70 area%, and symbol "-" indicates unmeasurable.

On the column "Present on all cutting edges?", "Yes" indicates affirmation, "No" indicates denial and symbol "-" indicates unmeasurable.

[Table 9]

| Type | | Maximum $Xi_{max}$ and minimum $Xi_{min}$ of variable Al and Ti contents | | | | | | | | | | | | | | |
|---|---|---|---|---|---|---|---|---|---|---|---|---|---|---|---|---|
| | | $x1_{max}$ | $x1_{min}$ | $x1_{max}-x2_{min}$ | $x2_{max}$ | $x2_{min}$ | $x2_{max}-x2_{min}$ | $x3_{max}$ | $x3_{min}$ | $x3_{max}-x3_{min}$ | $x4_{max}$ | $x4_{min}$ | $x4_{max}-x_{m4in}$ | 0.02 or more and 0.40 or less for all cutting edges? | Presence in network, layered, and granular form | Minimum distance between outer edges of each region (nm) |
| Examples | 1 | 0.61 | 0.59 | 0.02 | 0.61 | 0.59 | 0.02 | 0.61 | 0.59 | 0.02 | 0.61 | 0.59 | 0.02 | Yes | Yes | 2 |
| | 2 | 0.73 | 0.69 | 0.04 | 0.73 | 0.69 | 0.04 | 0.73 | 0.69 | 0.04 | 0.73 | 0.69 | 0.04 | Yes | Yes | 9 |
| | 3 | 0.94 | 0.58 | 0.36 | 0.94 | 0.58 | 0.36 | 0.94 | 0.58 | 0.36 | 0.94 | 0.58 | 0.36 | Yes | Yes | 88 |
| | 4 | 0.95 | 0.93 | 0.02 | 0.96 | 0.94 | 0.02 | 0.95 | 0.93 | 0.02 | 0.95 | 0.93 | 0.02 | Yes | Yes | 4 |
| | 5 | 0.93 | 0.86 | 0.07 | 0.93 | 0.86 | 0.07 | 0.93 | 0.86 | 0.07 | 0.93 | 0.86 | 0.07 | Yes | Yes | 17 |
| | 6 | 0.82 | 0.48 | 0.34 | 0.82 | 0.48 | 0.34 | 0.82 | 0.48 | 0.34 | 0.82 | 0.48 | 0.34 | Yes | Yes | 82 |
| | 7 | 0.84 | 0.76 | 0.08 | 0.84 | 0.76 | 0.08 | 0.84 | 0.76 | 0.08 | 0.84 | 0.76 | 0.08 | Yes | Yes | 18 |
| | 8 | 0.87 | 0.85 | 0.02 | 0.87 | 0.84 | 0.03 | 0.86 | 0.83 | 0.03 | 0.86 | 0.83 | 0.03 | Yes | Yes | 8 |
| | 9 | 0.86 | 0.80 | 0.06 | 0.86 | 0.80 | 0.06 | 0.86 | 0.80 | 0.06 | 0.86 | 0.80 | 0.06 | Yes | Yes | 16 |
| | 10 | 0.63 | 0.58 | 0.05 | 0.63 | 0.58 | 0.05 | 0.63 | 0.58 | 0.05 | 0.63 | 0.58 | 0.05 | Yes | Yes | 11 |
| | 11 | 0.74 | 0.69 | 0.05 | 0.74 | 0.69 | 0.05 | 0.74 | 0.69 | 0.05 | 0.74 | 0.69 | 0.05 | Yes | Yes | 12 |
| | 12 | 0.91 | 0.61 | 0.30 | 0.91 | 0.61 | 0.30 | 0.91 | 0.61 | 0.30 | 0.91 | 0.61 | 0.30 | Yes | Yes | 72 |
| | 13 | 0.96 | 0.94 | 0.02 | 0.96 | 0.94 | 0.02 | 0.96 | 0.93 | 0.03 | 0.96 | 0.93 | 0.03 | Yes | Yes | 6 |
| | 14 | 0.93 | 0.88 | 0.05 | 0.93 | 0.88 | 0.05 | 0.93 | 0.88 | 0.05 | 0.93 | 0.88 | 0.05 | Yes | Yes | 10 |
| | 15 | 0.85 | 0.45 | 0.40 | 0.85 | 0.45 | 0.40 | 0.85 | 0.45 | 0.40 | 0.85 | 0.45 | 0.40 | Yes | Yes | 95 |
| | 16 | 0.84 | 0.76 | 0.08 | 0.84 | 0.76 | 0.08 | 0.84 | 0.76 | 0.08 | 0.84 | 0.76 | 0.08 | Yes | Yes | 16 |
| | 17 | 0.88 | 0.84 | 0.04 | 0.88 | 0.84 | 0.04 | 0.88 | 0.84 | 0.04 | 0.88 | 0.84 | 0.04 | Yes | Yes | 8 |
| | 18 | 0.87 | 0.80 | 0.07 | 0.87 | 0.80 | 0.07 | 0.86 | 0.79 | 0.07 | 0.87 | 0.80 | 0.07 | Yes | Yes | 16 |
| | 19 | 0.94 | 0.92 | 0.02 | 0.94 | 0.92 | 0.02 | 0.94 | 0.92 | 0.02 | 0.94 | 0.92 | 0.02 | Yes | Yes | 5 |
| | 20 | 0.83 | 0.75 | 0.08 | 0.83 | 0.75 | 0.08 | 0.83 | 0.75 | 0.08 | 0.83 | 0.75 | 0.08 | Yes | Yes | 21 |
| | 21 | 0.65 | 0.56 | 0.09 | 0.65 | 0.56 | 0.09 | 0.65 | 0.56 | 0.09 | 0.65 | 0.56 | 0.09 | Yes | Yes | 22 |
| | 22 | 0.66 | 0.62 | 0.04 | 0.66 | 0.62 | 0.04 | 0.67 | 0.62 | 0.05 | 0.66 | 0.62 | 0.04 | Yes | Yes | 9 |
| | 23 | 0.86 | 0.80 | 0.06 | 0.86 | 0.80 | 0.06 | 0.86 | 0.80 | 0.06 | 0.86 | 0.80 | 0.06 | Yes | Yes | 15 |
| | 24 | 0.71 | 0.67 | 0.04 | 0.71 | 0.67 | 0.04 | 0.71 | 0.67 | 0.04 | 0.72 | 0.66 | 0.06 | Yes | Yes | 14 |
| | 25 | 0.75 | 0.70 | 0.05 | 0.75 | 0.70 | 0.05 | 0.75 | 0.70 | 0.05 | 0.75 | 0.70 | 0.05 | Yes | Yes | 13 |
| | 26 | 0.88 | 0.81 | 0.07 | 0.88 | 0.81 | 0.07 | 0.88 | 0.81 | 0.07 | 0.88 | 0.81 | 0.07 | Yes | Yes | 17 |
| | 27 | 0.78 | 0.74 | 0.04 | 0.78 | 0.74 | 0.04 | 0.78 | 0.73 | 0.05 | 0.78 | 0.74 | 0.04 | Yes | Yes | 10 |
| Comparative Examples | 1 | 0.60 | 0.56 | 0.04 | 0.61 | 0.54 | 0.07 | 0.60 | 0.56 | 0.04 | 0.62 | 0.54 | 0.08 | Yes | Yes | 19 |
| | 2 | - | - | - | - | - | - | - | - | - | - | - | - | - | - | - |
| | 3 | 0.62 | 0.56 | 0.06 | 0.63 | 0.55 | 0.08 | 0.62 | 0.56 | 0.06 | 0.63 | 0.55 | 0.08 | Yes | Yes | 20 |
| | 4 | 0.82 | 0.79 | 0.03 | 0.84 | 0.80 | 0.04 | 0.82 | 0.78 | 0.04 | 0.83 | 0.80 | 0.03 | Yes | Yes | 7 |
| | 5 | 0.71 | 0.67 | 0.04 | - | - | - | 0.71 | 0.67 | 0.04 | - | - | - | No | Yes | 9 |
| | 6 | 0.62 | 0.56 | 0.06 | 0.62 | 0.56 | 0.06 | 0.63 | 0.57 | 0.06 | 0.62 | 0.56 | 0.06 | Yes | Yes | 15 |
| | 7 | - | - | - | - | - | - | - | - | - | - | - | - | - | - | - |
| | 8 | 0.60 | 0.58 | 0.02 | 0.60 | 0.58 | 0.02 | 0.60 | 0.58 | 0.02 | 0.60 | 0.58 | 0.02 | Yes | Yes | 5 |
| | 9 | 0.83 | 0.79 | 0.04 | 0.83 | 0.77 | 0.06 | 0.83 | 0.78 | 0.05 | 0.83 | 0.77 | 0.06 | Yes | Yes | 14 |
| | 10 | 0.70 | 0.67 | 0.03 | - | - | - | 0.70 | 0.67 | 0.03 | - | - | - | No | Yes | 6 |
| | 11 | - | - | - | - | - | - | - | - | - | - | - | - | - | - | - |
| | 12 | - | - | - | - | - | - | - | - | - | - | - | - | - | - | - |
| | 13 | 0.85 | 0.79 | 0.06 | 0.89 | 0.84 | 0.05 | 0.85 | 0.80 | 0.05 | 0.89 | 0.87 | 0.02 | Yes | Yes | 4 |
| | 14 | - | - | - | - | - | - | - | - | - | - | - | - | - | - | - |
| | 15 | 0.86 | 0.78 | 0.08 | 0.87 | 0.77 | 0.10 | 0.85 | 0.78 | 0.07 | 0.87 | 0.76 | 0.11 | Yes | Yes | 26 |

In Table 9, "Presence in network, layered, and granular form" indicates that "regions that have a difference of +1% or more (high Al content regions) and regions that have a difference of -1% or more (low Al content regions) from the average value ($x_{avg}$*) in the regions containing variable amounts of Al and Ti are present in network, layered, and granular form; "Yes" indicates distribution; "No" indicates no distribution; and "minimum distance between the outer edges of each region" indicates "the distance between the outer edges of the high Al-containing region separated by the low Al-containing region, or the distance between the outer edges of the low Al-containing region separated by the high Al-containing region.

On the column "0.02 or more and 0.40 or less for all cutting edges?", "Yes" indicates affirmation, "No" indicates denial and Symbol "-" in the other columns indicates unmeasurable.

[Table 10]

| Type | | Texture coefficient TC(200) of flank face | | | | | | Average grain width W (μm) | | | | Aspect ratio A | | | | Do all cutting edges have desired ranges of A and W? |
|---|---|---|---|---|---|---|---|---|---|---|---|---|---|---|---|---|
| | | $TC_1$ | $TC_2$ | $TC_3$ | $TC_4$ | Do all cutting edges have a Tcavg of 1.0 to 6.0? | $\sigma TC/Tc_{avg}$ | $W_1$ | $W_2$ | $W_3$ | $W_4$ | $A_1$ | $A_2$ | $A_3$ | $A_4$ | |
| Examples | 1 | 2.4 | 2.9 | 3.5 | 3.4 | Yes | 0.14 | 0.12 | 0.13 | 0.12 | 0.13 | 1.7 | 2.1 | 1.8 | 1.9 | No |
| | 2 | 1.6 | 1.4 | 1.4 | 1.7 | Yes | 0.09 | 0.17 | 0.21 | 0.20 | 0.15 | 1.7 | 1.8 | 1.9 | 1.7 | No |
| | 3 | 1.9 | 1.8 | 1.5 | 1.3 | Yes | 0.15 | 1.14 | 1.01 | 1.05 | 1.15 | 6.4 | 7.0 | 6.2 | 6.5 | Yes |
| | 4 | 1.5 | 1.5 | 1.6 | 1.5 | Yes | 0.03 | 1.05 | 1.00 | 1.11 | 1.12 | 2.1 | 2.6 | 2.2 | 2.0 | Yes |
| | 5 | 2.0 | 2.0 | 2.0 | 2.0 | Yes | 0.00 | 0.81 | 0.90 | 0.85 | 0.82 | 2.9 | 3.2 | 3.4 | 3.2 | Yes |
| | 6 | 1.4 | 1.4 | 1.8 | 1.9 | Yes | 0.14 | 0.78 | 0.85 | 0.81 | 0.79 | 8.1 | 7.0 | 7.4 | 8.4 | Yes |
| | 7 | 2.5 | 2.4 | 2.0 | 1.6 | Yes | 0.17 | 0.52 | 0.48 | 0.46 | 0.55 | 4.8 | 4.4 | 4.6 | 5.0 | Yes |
| | 8 | 1.5 | 1.5 | 1.2 | 1.5 | Yes | 0.09 | 0.48 | 0.50 | 0.47 | 0.51 | 1.5 | 1.8 | 1.6 | 1.5 | No |
| | 9 | 2.0 | 2.1 | 2.0 | 1.9 | Yes | 0.04 | 0.62 | 0.65 | 0.59 | 0.61 | 2.0 | 2.4 | 2.3 | 2.2 | Yes |
| | 10 | 2.6 | 2.9 | 2.4 | 3.4 | Yes | 0.13 | 0.14 | 0.12 | 0.13 | 0.15 | 2.0 | 1.8 | 2.0 | 1.9 | No |
| | 11 | 1.3 | 1.3 | 0.9 | 1.5 | No | 0.17 | 0.21 | 0.17 | 0.18 | 0.20 | 1.5 | 1.9 | 1.5 | 1.8 | No |
| | 12 | 1.7 | 1.7 | 1.6 | 1.7 | Yes | 0.03 | 1.31 | 1.22 | 1.28 | 1.20 | 11.0 | 10.6 | 11.1 | 10.3 | No |
| | 13 | 1.6 | 1.2 | 1.5 | 1.8 | Yes | 0.14 | 1.22 | 1.20 | 1.19 | 1.21 | 8.0 | 8.4 | 8.5 | 8.8 | No |
| | 14 | 2.5 | 2.4 | 2.6 | 2.3 | Yes | 0.05 | 0.89 | 0.87 | 0.89 | 0.86 | 9.5 | 10.6 | 10.1 | 9.7 | No |
| | 15 | 1.6 | 1.6 | 2.0 | 2.0 | Yes | 0.11 | 0.78 | 0.77 | 0.79 | 0.75 | 8.5 | 9.0 | 8.6 | 8.6 | Yes |
| | 16 | 2.0 | 2.4 | 2.0 | 2.1 | Yes | 0.08 | 0.55 | 0.58 | 0.53 | 0.60 | 6.6 | 6.8 | 6.7 | 6.8 | Yes |
| | 17 | 1.8 | 1.7 | 1.3 | 1.1 | Yes | 0.19 | 0.49 | 0.51 | 0.48 | 0.52 | 2.0 | 1.6 | 2.4 | 2.1 | No |
| | 18 | 1.0 | 0.9 | 1.5 | 1.1 | No | 0.20 | 0.64 | 0.60 | 0.61 | 0.63 | 2.1 | 2.8 | 2.2 | 2.4 | Yes |
| | 19 | 3.4 | 3.6 | 3.6 | 3.5 | Yes | 0.02 | 1.29 | 1.18 | 1.26 | 1.15 | 2.0 | 2.1 | 2.2 | 2.2 | No |
| | 20 | 3.9 | 4.0 | 3.9 | 4.0 | Yes | 0.01 | 0.42 | 0.33 | 0.48 | 0.39 | 3.2 | 3.5 | 3.6 | 3.0 | Yes |
| | 21 | 3.8 | 3.7 | 3.8 | 3.8 | Yes | 0.01 | 0.33 | 0.40 | 0.35 | 0.46 | 7.5 | 7.1 | 8.2 | 8.1 | Yes |
| | 22 | 3.6 | 3.6 | 3.6 | 3.6 | Yes | 0.00 | 0.56 | 0.52 | 0.44 | 0.49 | 7.2 | 6.4 | 7.0 | 6.2 | Yes |
| | 23 | 4.4 | 4.6 | 4.4 | 4.6 | Yes | 0.02 | 0.52 | 0.50 | 0.47 | 0.41 | 1.7 | 2.1 | 1.6 | 1.9 | No |
| | 24 | 6.0 | 6.0 | 6.0 | 6.0 | Yes | 0.00 | 0.45 | 0.49 | 0.41 | 0.50 | 11.6 | 11.1 | 12.4 | 11.8 | No |
| | 25 | 4.1 | 4.1 | 4.0 | 4.0 | Yes | 0.01 | 1.06 | 1.01 | 1.12 | 1.05 | 4.9 | 5.2 | 5.4 | 4.9 | Yes |
| | 26 | 6.0 | 6.0 | 6.0 | 6.0 | Yes | 0.00 | 0.53 | 0.49 | 0.44 | 0.56 | 3.1 | 2.9 | 3.5 | 3.0 | Yes |
| | 27 | 4.9 | 4.8 | 5.0 | 4.9 | Yes | 0.01 | 0.13 | 0.09 | 0.12 | 0.11 | 9.0 | 8.8 | 9.6 | 9.1 | No |
| Comparative Examples | 1 | - | - | - | - | - | - | 0.14 | 0.09 | 0.15 | 0.07 | 1.8 | 1.1 | 1.4 | 2.0 | No |
| | 2 | 0.8 | 2.4 | 1.1 | 2.8 | No | 0.48 | 0.09 | 0.07 | 0.07 | 0.08 | 1.6 | 1.2 | 1.9 | 1.5 | No |
| | 3 | 1.9 | 2.1 | 2.5 | 2.9 | Yes | 0.16 | 1.32 | 0.82 | 1.26 | 0.83 | 4.0 | 3.3 | 4.2 | 3.9 | No |
| | 4 | 0.2 | - | 0.0 | - | - | - | 0.08 | 0.07 | 0.05 | 0.08 | 2.0 | 1.4 | 1.9 | 1.6 | No |
| | 5 | 1.8 | - | 1.4 | - | - | - | 1.91 | 1.00 | 1.90 | 1.14 | 2.9 | 1.4 | 2.8 | 1.5 | No |
| | 6 | 1.9 | 3.1 | 2.1 | 2.6 | Yes | 0.19 | 0.18 | 0.15 | 0.22 | 0.16 | 2.5 | 1.4 | 2.8 | 1.8 | No |
| | 7 | 1.0 | 1.1 | 2.1 | 2.0 | Yes | 0.32 | 0.12 | 0.10 | 0.09 | 0.13 | 1.5 | 1.0 | 1.4 | 1.2 | No |
| | 8 | 2.3 | 2.5 | 1.8 | 2.1 | Yes | 0.12 | 1.72 | 1.24 | 1.66 | 1.45 | 3.9 | 2.4 | 4.1 | 2.6 | No |
| | 9 | 0.6 | 0.5 | - | 1.4 | - | 0.48 | 0.13 | 0.12 | 0.11 | 0.12 | 1.4 | 1.3 | 1.1 | 1.5 | No |
| | 10 | 1.0 | - | 1.2 | - | - | - | 1.77 | 0.85 | 1.71 | 0.82 | 3.4 | 2.8 | 3.4 | 2.9 | No |
| | 11 | 1.2 | 2.4 | 1.8 | 2.7 | Yes | 0.28 | 0.52 | 0.34 | 0.46 | 0.22 | 1.4 | 1.5 | 1.9 | 1.6 | No |
| | 12 | - | - | - | - | - | - | 0.42 | 0.46 | 0.40 | 0.44 | 2.6 | 3.0 | 3.1 | 2.8 | Yes |
| | 13 | 0.5 | 1.5 | 0.9 | 2.0 | No | 0.47 | 0.45 | 0.39 | 0.46 | 0.28 | 2.4 | 3.0 | 3.6 | 2.2 | Yes |
| | 14 | 4.4 | 5.0 | 4.8 | 5.2 | Yes | 0.06 | 0.14 | 0.11 | 0.16 | 0.13 | 1.6 | 1.1 | 1.2 | 1.3 | No |
| | 15 | 0.9 | 1.8 | 1.0 | 1.4 | No | - | 0.81 | 0.56 | 0.78 | 0.63 | 2.1 | 2.5 | 2.6 | 2.2 | Yes |

In Table 10, TCi (where i = 1 to 4) under the column TC(200) is TCi (200) and $\sigma_{TC}$ is $\sigma_{TC(200)}$. "Yes" indicates affirmative, "No" indicates denial, and Symbol "-" indicates unmeasurable.

Each of the coated tool of the aforementioned Examples 1 to 9 and Comparative Examples 1 to 5, coated the aforementioned various substrates A to C (SEMT13T3AGSN shape) was all subjected to single-blade cutting: Each substrate was clamped to the tip of an alloy steel cutter having a cutter diameter of 80 mm using a fixture into a single blade, and Cutting Test 1, a dry high-speed face milling and center cutting operation on carbon steel, was conducted as shown below.

All four cutting edges of each coated tool were subjected to measurement of the width of flank wear of the cutting edges every one minute of cutting, and the cutting time until the width of flank wear reaches 0.2 mm or more, indicating the life-determining criterion, was measured as the life time of the tool. The average and standard deviation were then calculated. Table 11 shows the results of Cutting Test 1.

Cutting Test 1: Dry high-speed face milling, center cutting

Cutter diameter: 80 mm, single-blade cutting
Workpiece: JIS S45C block material 60 mm wide and 200 mm long
Rotation Speed: 1393/min
Cutting speed: 350 m/min
Depth of cut: 2.0mm
Feed rate per blade: 0.2 mm/edge
(Reference, Normal cutting speed is 200 m/min)

[Table 11]

| Type | | Cutting time to life in Cutting test 1 (minutes) | | Standard deviation/average of cutting times to life | Type | | Cutting time to life in Cutting test 1 (minutes) | | Standard deviation/average of cutting times to life |
|---|---|---|---|---|---|---|---|---|---|
| | | Average | Standard deviation | | | | Average | Standard deviation | |
| Examples | 1 | 8.5 | 0.9 | 0.10 | Comparative Examples | 1 | 2.0 | 0.7 | 0.35 |
| | 2 | 8.8 | 0.4 | 0.05 | | 2 | 1.5 | 0.5 | 0.33 |
| | 3 | 10.3 | 0.4 | 0.04 | | 3 | 2.8 | 1.8 | 0.65 |
| | 4 | 9.5 | 0.5 | 0.05 | | 4 | 5.0 | 1.6 | 0.32 |
| | 5 | 12.0 | 0.7 | 0.06 | | 5 | 4.3 | 1.9 | 0.45 |
| | 6 | 10.8 | 0.8 | 0.08 | | | | | |
| | 7 | 11.5 | 1.1 | 0.10 | | | | | |
| | 8 | 9.0 | 0.7 | 0.08 | | | | | |
| | 9 | 9.3 | 0.4 | 0.05 | | | | | |

In Table 11, the cutting time to life (minutes) represents the time (minutes) to life due to occurrence of chipping before the flank face reaches the wear width.

Each of the coated tool of Examples 10 to 18 and Comparative Examples 6 to 10, coated substrates D to F (ISO standard CNMG 120412 shape) was all screwed to the tips of alloy steel tools with a fixture, and Cutting Test 2, a dry, high-speed intermittent cutting process of ductile cast iron, was conducted as described below.

The width of the flank wear at all the four cutting edges was measured every 0.5 minutes of cutting, the sharp corner edges on the upper and lower faces of each coated tool, respectively, and the cutting time when the flank wear width reaches 0.3 mm or more, which is the life-determining criterion, was measured as the time until the end of life. The average and standard deviation were then obtained. Table 12 shows the results of Cutting Test 2.

Cutting Test 2: Dry high-speed intermittent cutting

Workpiece: JIS FCD700 round bar with 4 longitudinal grooves equally spaced in the longitudinal direction
Cutting speed: 400 m/min
Depth of cut: 1.0mm
Feed: 0.2 mm/rev
(Reference, Normal cutting speed is 150 to 200 m/min)

[Table 12]

| Type | | Cutting time to life in Cutting test 2 (minutes) | | Standard deviation/average of cutting times to life | Type | | Cutting time to life in Cutting test 2 (minutes) | | Standard deviation/average of cutting times to life |
|---|---|---|---|---|---|---|---|---|---|
| | | Average | Standard deviation | | | | Average | Standard deviation | |
| Examples | 10 | 3.8 | 0.3 | 0.08 | Comparative Examples | 6 | 0.8 | 0.3 | 0.38 |
| | 11 | 3.9 | 0.3 | 0.06 | | 7 | 0.9 | 0.3 | 0.29 |
| | 12 | 5.5 | 0.4 | 0.07 | | 8 | 1.0 | 0.6 | 0.58 |
| | 13 | 4.5 | 0.4 | 0.09 | | 9 | 1.4 | 0.6 | 0.46 |
| | 14 | 5.8 | 0.3 | 0.05 | | 10 | 1.6 | 0.5 | 0.29 |
| | 15 | 4.8 | 0.3 | 0.06 | | | | | |
| | 16 | 6.0 | 0.4 | 0.07 | | | | | |
| | 17 | 4.3 | 0.3 | 0.07 | | | | | |
| | 18 | 5.0 | 0.4 | 0.08 | | | | | |

In Table 12, the cutting time (minutes) to life represents the time (minutes) to life due to occurrence of chipping before the flank face reaches the wear width.

For Examples 19 to 27 and Comparative Examples 11 to 15, substrates A to C (SEMT13T3AGSN shape) were all clamped to tip of an alloy steel cutter having a 80 mm diameter using a fixture into a single blade, and Cutting Test 3, which is a dry high-speed face milling and center cutting process of alloy steel, was conducted as shown below.

In all four cutting edges of each tool substrate, the width of flank wear of the cutting edge was measured every 0.5 minutes of cutting, and the cutting time at which the width of flank wear reaches 0.2 mm or more, which is the life-determining criterion, was measured as the time until the end of life. The average and standard deviation were then calculated. Table 13 shows the results of Cutting Test 3.

Cutting Test 3: Dry high-speed face milling, center cutting

Cutter diameter: 80 mm, single-blade cutting
Workpiece material: JIS SCM440, 60 mm wide, 200 mm long block material
Rotation speed: 1592/min
Cutting speed: 400 m/min
Depth of cut: 2.0mm
Feed rate per blade: 0.2 mm/edge
(Reference, Normal cutting speed is 200 m/min)

[Table 13]

| Type | | Cutting time to life in Cutting test 3 (minutes) | | Standard deviation/average of cutting times to life | Type | | Cutting time to life in Cutting test 3 (minutes) | | Standard deviation/average of cutting times to life |
|---|---|---|---|---|---|---|---|---|---|
| | | Average | Standard deviation | | | | Average | Standard deviation | |
| Examples | 19 | 9.3 | 0.2 | 0.02 | Comparative Examples | 11 | 3.2 | 0.9 | 0.28 |
| | 20 | 10.3 | 0.5 | 0.05 | | 12 | 2.6 | 0.9 | 0.33 |
| | 21 | 10.1 | 0.5 | 0.05 | | 13 | 2.3 | 0.6 | 0.25 |
| | 22 | 12.2 | 0.6 | 0.05 | | 14 | 3.6 | 1.0 | 0.27 |
| | 23 | 9.3 | 0.2 | 0.02 | | 15 | 2.1 | 0.6 | 0.27 |
| | 24 | 8.4 | 0.2 | 0.02 | | | | | |
| | 25 | 12.1 | 0.4 | 0.03 | | | | | |
| | 26 | 10.2 | 0.2 | 0.02 | | | | | |
| | 27 | 11.3 | 0.5 | 0.04 | | | | | |

In Table 13, the cutting time (minutes) to life represents the time (minutes) to life due to occurrence of chipping before the flank face reaches the wear width.

The results shown in Tables 11, 12, and 13 demonstrate that the AlTiCN layers in Examples 1 to 27 have uniform thickness and homogeneous structure at each cutting edge, and all the cutting edges have high thermal cracking and chipping resistance, and thus exhibit superior long-term wear resistance at all cutting edges. Thus, no thermal cracking or chipping was observed at all the cutting edges and exhibit excellent wear resistance over a long period of time without thermal cracking and chipping, even during high-speed intermittent cutting of carbon steel, cast iron, and alloy steel.

In contrast, the results shown in Tables 11, 12, and 13 indicate that the thickness and microstructure of the AlTiCN layer in Comparative Examples 1 through 15 are not uniform or homogeneous among the cutting edges and thus, the thermal crack resistance and chipping resistance are also not uniform. Some of the four cutting edges of each tool exhibits shorter service lives during use in high-speed intermittent cutting of carbon steel, cast iron, and alloy steel, resulting in a shorter average time to service life and a larger variation (standard deviation/average) in time to service life.

In conclusion, all Examples exhibits longer average service lives, smaller variations in average service life, and uniform superior cutting performance, in comparison with Comparative Examples.

The disclosed embodiments are in all respects illustrative only and are not restrictive. The scope of the invention is indicated by claims, not the embodiments, and is intended to include all modifications within the meaning and scope of the claims and equivalents.

**Reference Numerals**

1 rake face
2 flank face
3 ridge of primary cutting edge
4 ridge of secondary cutting edge
5 corner of cutting edge
6 substrate
7 gas ejecting pipe
8 gas group A
9 gas group B
11 reaction vessel
12 external heater
13 tray
14 gas feed pipe
15 space between trays
16 rotation shaft
17 gas group A and gas group B
18 to 20 ejecting hole

**Claims**

**1.** A surface coated cutting tool comprising a substrate and a coating layer disposed on the substrate, wherein,

(a) the coating layer comprises a complex nitride or carbonitride layer of Al and Ti including crystal grains with a face-centered cubic structure of a NaCl type,
(b) the tool includes a plurality of cutting edges having flank faces of the same shape, and the complex nitride or carbonitride layer of Al and Ti of all the flank faces has a composition represented by the formula $(Al_xTi_{1-x})(C_yN_{1-y})$ (where the average content $x_{avg}$ of x's is 0.60 or more and 0.95 or less, and the average content $y_{avg}$ of y's is 0.0000 or more and 0.0050 or less),
(c) 200 diffraction lines measured with an X-ray diffractometer at all the flank faces and assigned to the crystal grains with a face-centered cubic structure of a NaCl type in the coating layer have respective intensities, and the ratio $\sigma_{I(200)}/I(200)$ is 0.00 or more and 0.20 or less where I(200) is the average intensity and $\sigma_{I(200)}$ is the standard deviation thereof,
(d) the coating layers of the cutting edges have respective intra-edge thicknesses Lm's on a line 100 $\mu$m away from the ridges of the cutting edges in the direction of the flank faces, and the ratio $\sigma_L/L_{avg}$ is 0.00 or more and 0.20 or less where $L_{avg}$ is the inter-edge average thickness of the intra-edge average thicknesses Lm's and $\sigma_L$ is the standard deviation thereof, and
(e) the complex nitride or carbonitride layer of Al and Ti of the flank faces of all the cutting edges contains columnar crystals having regions that satisfy the relation $0.02 \leq x_{max}-x_{min} \leq 0$ 0.40, where $x_{max}$ is the average value of the maxima $x_{max}$* and $x_{min}$ is the average value of the minima $x_{min}$* of x's.

**2.** The surface coated cutting tool according to Claim 1, wherein the average value $TC_{avg}(200)$ of the texture coefficient TC(200) of the crystal grains with the face-centered cubic structure of the NaCl type contained in the coating layer on the flank faces of all the cutting edges is 1.0 or more and 6.0 or less.

**3.** The surface coated cutting tool according to Claim 1 or 2, wherein, on each of the flank faces of all the cutting edges, the average value $TC_{avg}(200)$ and the standard deviation $\sigma_{TC(200)}$ of the texture coefficient TC(200) of the crystal grains with a face-centered cubic structure of a NaCl type contained in the coating layer satisfy a ratio $\sigma_{TC}(200)/TC_{avg}(200)$ of 0.00 or more and 0.10 or less.

**4.** The surface coated cutting tool according to Claim 1, wherein, on each of the flank faces of all the cutting edges, a region containing variable amounts of Al and Ti in the coating layer occupies 70 area percent or more in a longitudinal section of the coating layer.

**5.** The surface coated cutting tool according to Claim 1, wherein, on each of the flank faces of all the cutting edges, the columnar crystals of the complex nitride or carbonitride layer of Al and Ti has an average width W of 0.10 μm or more and 1.20 μm or less and an average aspect ratio A of 2.0 or more and 10.0 or less.

**6.** The surface coated cutting tool according to Claim 1, wherein the Al and Ti complex nitride layer or complex carbonitride layer contains chlorine in an amount of 0.005 atomic percent or more and 0.500 atomic percent or less.

[Fig.1]

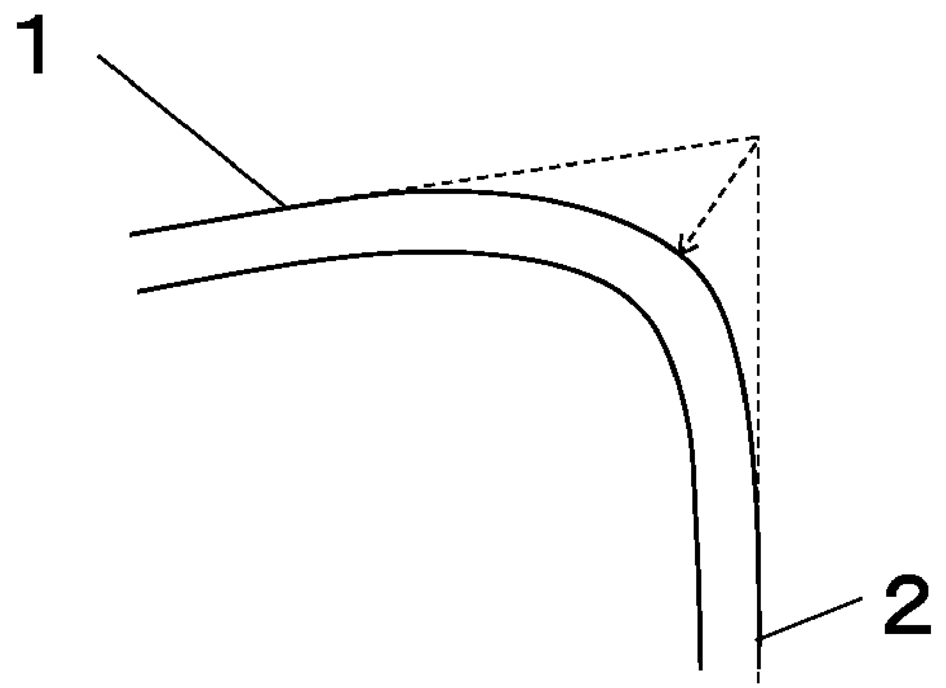


[Fig.2]

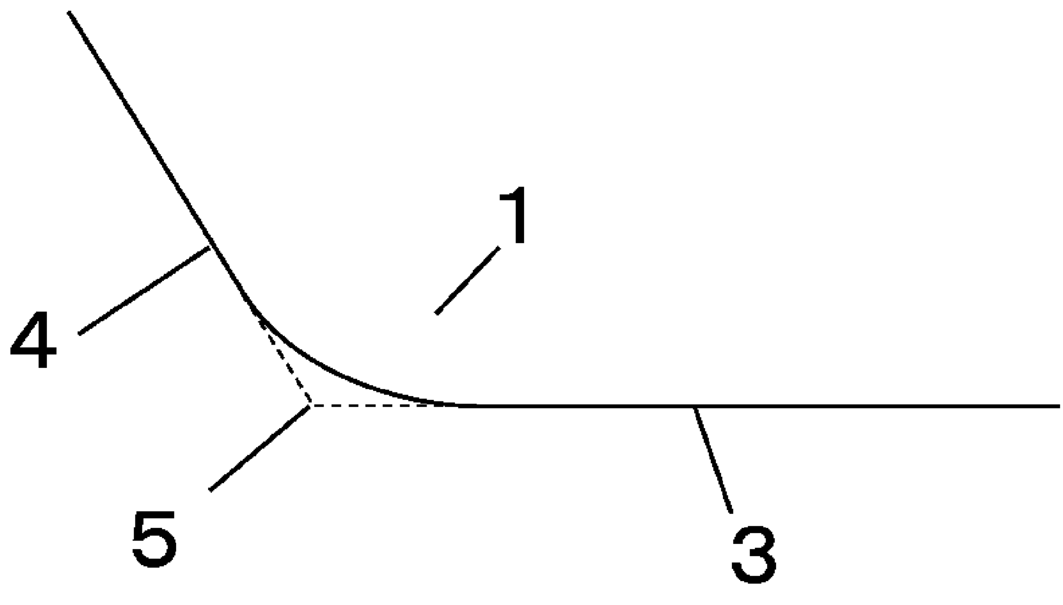


[Fig.3]

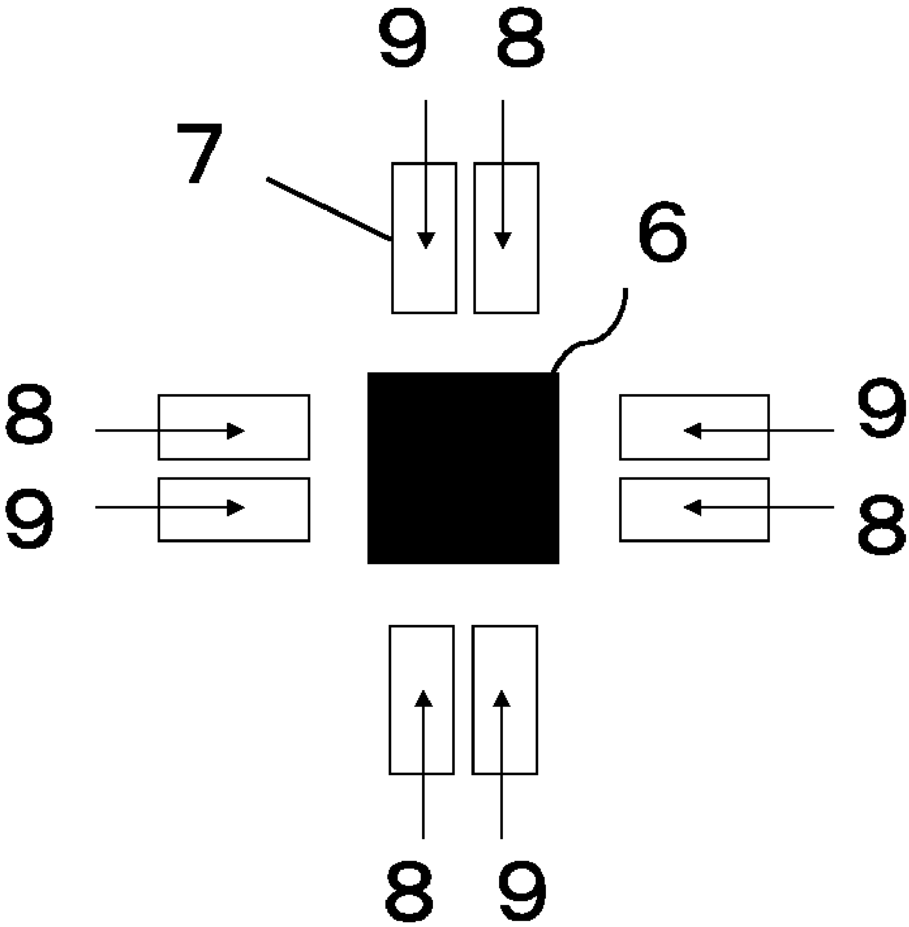


[Fig.4]

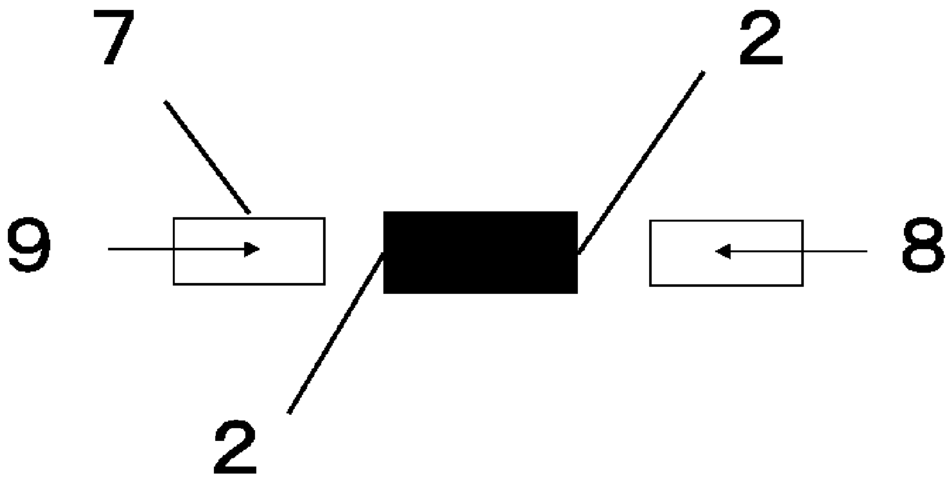

[Fig.5]

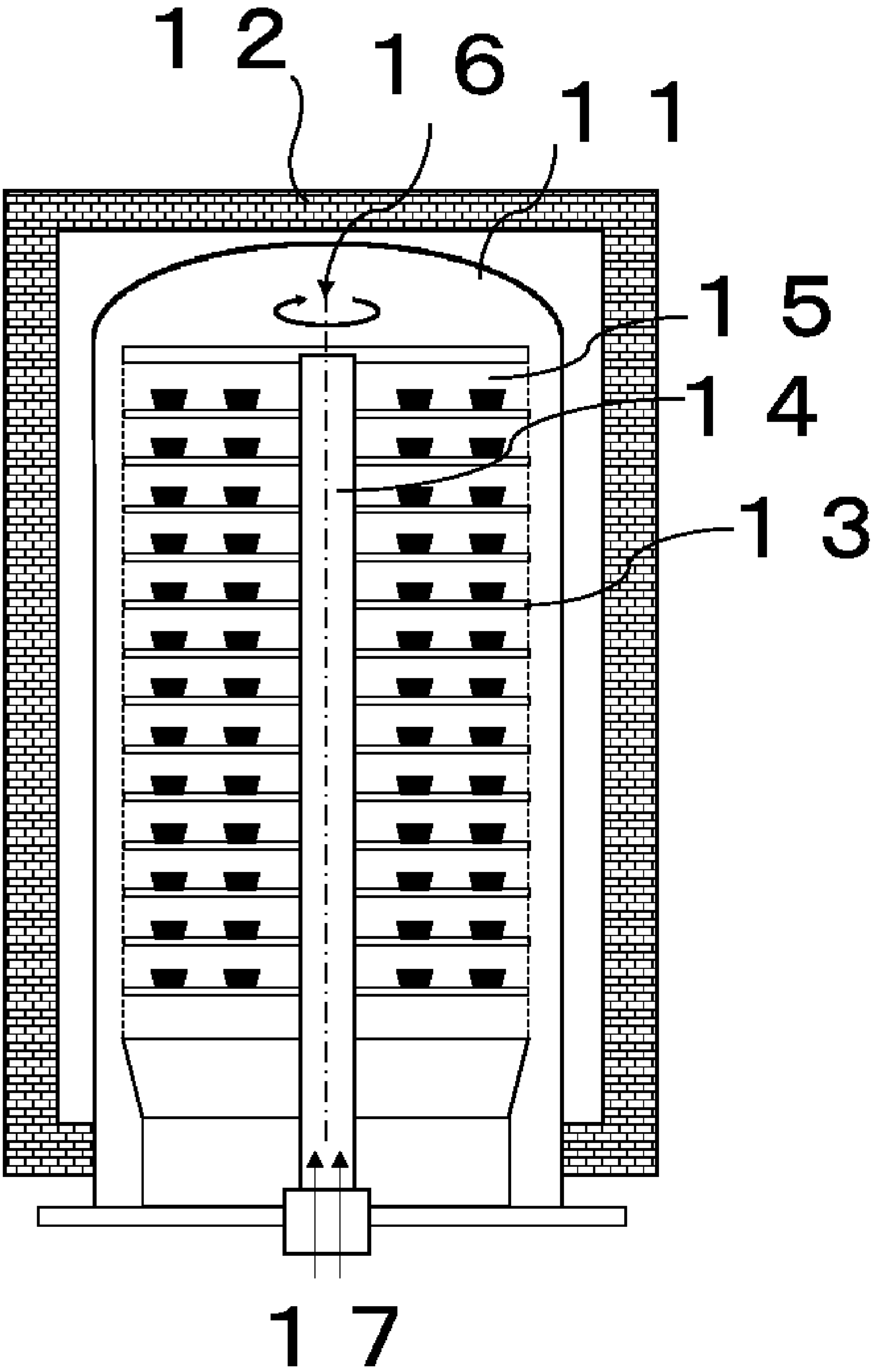

[fig.6]

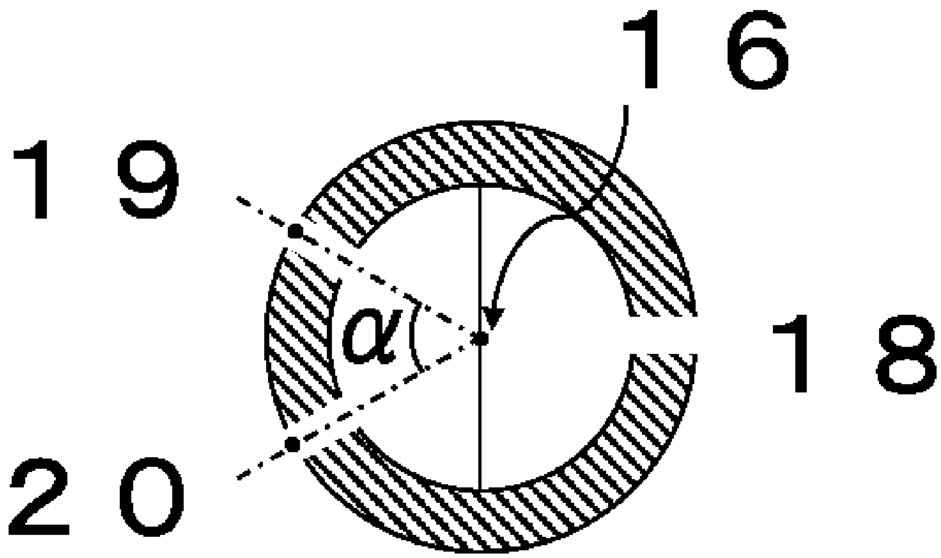

## INTERNATIONAL SEARCH REPORT

International application No. **PCT/JP2023/013155**

**A. CLASSIFICATION OF SUBJECT MATTER**

***B23B 27/14***(2006.01)i; ***B23C 5/16***(2006.01)i; ***C23C 16/34***(2006.01)i; ***C23C 16/36***(2006.01)i
FI: B23B27/14 A; B23C5/16; C23C16/34; C23C16/36

According to International Patent Classification (IPC) or to both national classification and IPC

**B. FIELDS SEARCHED**

Minimum documentation searched (classification system followed by classification symbols)

B23B27/14; B23C5/16; C23C16/34; C23C16/36

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2021-154415 A (MITSUBISHI MATERIALS CORP) 07 October 2021 (2021-10-07) entire text, all drawings | 1-6 |
| A | JP 2009-83086 A (SUMITOMO ELECTRIC HARDMETAL CORP) 23 April 2009 (2009-04-23) entire text, all drawings | 1-6 |
| P, A | WO 2022/172954 A1 (MOLDINO TOOL ENGINEERING LTD) 18 August 2022 (2022-08-18) entire text, all drawings | 1-6 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **06 June 2023** | **20 June 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**
**Information on patent family members**

International application No.
**PCT/JP2023/013155**

| Patent document cited in search report | Publication date (day/month/year) | Patent family member(s) | Publication date (day/month/year) |
|---|---|---|---|
| JP 2021-154415 A | 07 October 2021 | (Family: none) | |
| JP 2009-83086 A | 23 April 2009 | (Family: none) | |
| WO 2022/172954 A1 | 18 August 2022 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2022056507 A
- JP 2017020111 A